(19) Europäisches Patentamt
European Patent Office
Office européen des brevets

(11) **EP 4 200 459 B1**

(12) **EUROPÄISCHE PATENTSCHRIFT**

(45) Veröffentlichungstag und Bekanntmachung des Hinweises auf die Patenterteilung:
**01.05.2024   Patentblatt 2024/18**

(21) Anmeldenummer: **21769093.2**

(22) Anmeldetag: **23.08.2021**

(51) Internationale Patentklassifikation (IPC):
**C23C 14/24** *(2006.01)*       **C23C 14/56** *(2006.01)*
**C23C 14/54** *(2006.01)*       **C23C 14/16** *(2006.01)*

(52) Gemeinsame Patentklassifikation (CPC):
**C23C 14/542; C23C 14/16; C23C 14/24;**
**C23C 14/545; C23C 14/562**

(86) Internationale Anmeldenummer:
**PCT/EP2021/073274**

(87) Internationale Veröffentlichungsnummer:
**WO 2022/038296 (24.02.2022 Gazette 2022/08)**

(54) **PVD-VERFAHREN UND VORRICHTUNG HIERFÜR**

PVD PROCESS AND DEVICE THEREFOR

PROCÉDÉ DE DÉPÔT PHYSIQUE EN PHASE VAPEUR ET DISPOSITIF ASSOCIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.08.2020   DE 102020121923**

(43) Veröffentlichungstag der Anmeldung:
**28.06.2023   Patentblatt 2023/26**

(73) Patentinhaber:
- **voestalpine Stahl GmbH**
  **4020 Linz (AT)**
- **Materials Center Leoben Forschung GmbH**
  **8700 Leoben (AT)**

(72) Erfinder:
- **ESSL, Werner**
  **8700 Leoben (AT)**

- **ECKER, Werner**
  **8700 Leoben (AT)**
- **REISS, Georg**
  **8700 Leoben (AT)**
- **KOLNBERGER, Siegfried**
  **4061 Pasching (AT)**
- **STECHAUNER, Georg**
  **4030 Linz (AT)**
- **VANDEN BRANDE, Pierre**
  **6377 Seelisberg (CH)**

(74) Vertreter: **HGF**
**HGF Europe LLP**
**Neumarkter Straße 18**
**81673 München (DE)**

(56) Entgegenhaltungen:
**EP-A1- 2 937 442       JP-A- S58 133 374**
**US-A- 4 051 270       US-A1- 2010 272 921**

**Beschreibung**

Die Erfindung betrifft ein PVD-Verfahren und eine Vorrichtung hierfür.

Es ist bekannt, Substrate mittels Dampfphasenabscheidung zu beschichten. B. Schuhmacher ("Innovative steel strip coatings by means of PVD in a continuous pilot line: process technology and coating development", Surface and Coatings Technology 163-164 (2003) 703-709) beschreibt eine PVD- Beschichtungsvorrichtung, die ein optimiertes Düsendesign aufweist. Die Beschichtung erfolgt in einer Produktionslinie, indem das zu beschichtende Substrat an den Düsen entlang geführt wird. Dabei werden Schichten erzeugt, deren Schichtdicke um $\leq \pm 10\%$ variiert.

Die US8436318 B2 beschreibt eine PVD-Anlage, die starre Bleche als elektrostatische Abschirmelemente verwendet. Dabei wird der Gasfluss nur in eine Richtung durchgelassen, indem die gegenüber liegende Kammerseite elektrostatisch abgeschirmt wird. Eine gezielte Steuerung des Gasflusses liegt nicht vor. Homogene Schichten können mit dieser Methode nicht erzeugt werden. Bei schmäleren Bändern kommt es zu Problemen in der Randschicht. Breite Bänder sind nicht darstellbar.

Aus der EP 2231895 A1 ist eine Beschichtungsvorrichtung bekannt, bei der die Einstellung der Schichtdicke mittels Leitbleche erfolgt. Die Leitbleche sind in gleichmäßigen Abständen zu einander angeordnet und stellen eine blendenartige Abschirmung des Substrats dar. Ihre Drehachse erlaubt eine Verstellung in zwei Positionen: geöffnet oder geschlossen. Diese Vorrichtung enthält jedoch keine spezielle Ansteuerung, deshalb wird mit der Vorrichtung keine homogene Schichtdickenverteilung erreicht. Außerdem wird bei geschlossenen Klappen ein erheblicher Strömungswiderstand erzeugt. Dies erhöht den Energieverbrauch und ist somit mit erhöhten Produktionskosten verbunden. Außerdem kommt es bei einem hohen Strömungswiderstand zu einem Aufstau von Partikeln und damit zu hohen Partikelkonzentrationen.

Das Phänomen der diffusen Oberflächenreflektion ist dem Stand der Technik bekannt und tritt insbesondere in folgenden Fällen auf:

a) Auf ebenen Metalloberflächen, die in Hochvakuum und/oder bei hohen Temperaturen behandelt wurden;
b) Wenn das Molmassenverhältnis der Gas- und Substratmoleküle klein ist;
c) Wenn die Translationsenergie der Gasmoleküle im Vergleich zur Oberflächenenergie mehr als ein Paar Elektronenvolt beträgt.

Weist der Gasstrom in einer PVD-Anlage ein diffuses Reflexionsverhalten auf, kommt es zu einer Verminderung der Strömung im Bereich der Wände. Bei diffuser Oberflächenreflexion an den seitlichen Beschichtungskammerwänden nimmt die Schichtdicke am Substrat im Randbereich stark ab, da die an den Oberflächen der seitlichen Wände diffus reflektierten Atome die Strömung in Richtung des Substrates behindern. Außerdem erhöht sich der Materialverbrauch um die gewünschte Schichtdicke im Randbereich zu erreichen. Demzufolge führt das diffuse Reflexionsverhalten zu einer Verringerung der Effizienz des Verdampfungsprozesses.

Um die genannten Effekte zu verringern, wurden bis jetzt komplex aufgebaute Beschichtungsanlagen unter Einsatz aufwendiger mechanischer Systeme verwendet. Jedoch wurden hierbei hohe Strömungswiderstände geschaffen und die gewünschte Homogenität der Beschichtung konnte nicht sichergestellt werden.

Es ist ebenfalls bekannt, Substrate mittels Schmelztauchverzinken oder elektrolytisch zu beschichten. Hierbei ist allerdings die Legierungsauswahl stark eingeschränkt.

Die enge Legierungsauswahl beim Schmelztauchverzinken wird durch die Schmelztemperatur der Beschichtungslegierung bedingt. Somit können nur Substanzen abgeschieden werden, deren Schmelzpunkte nicht zu weit auseinander liegen.

Bei einer elektrolytischen Beschichtung wiederum ist die Legierungsauswahl durch die Natur der Substanzen beschränkt, beispielsweise durch Löslichkeit und/oder Polarität. Da die elektrolytische Abscheidung in einem wässrigen Medium stattfindet, kann ein elektrolytisches Verfahren für gewisse Substanzen, wie beispielsweise organische Moleküle oder Aluminium, keine Anwendung finden.

Aufgabe der Erfindung ist es, ein Beschichtungsverfahren zu schaffen, welches bei bandförmigen Substraten homogene Schichtdicken, insbesondere variabel adaptierbar bezogen auf die Bandbreite, mit einer maximal möglichen Zusammensetzungsvariation und mit einer hohen Energieeffizienz ermöglicht.

Die Aufgabe wird mit den Merkmalen des Anspruchs 1 gelöst.

Vorteilhafte Weiterbildungen sind in den hiervon abhängigen Unteransprüchen gekennzeichnet.

Eine weitere Aufgabe der Erfindung ist es, eine Vorrichtung zur Durchführung des Verfahrens zu schaffen, mit dem homogene Schichtdicken bei bandförmigen Substraten, insbesondere homogene Schichtdicken bei unterschiedlichen Substratbreiten bei Minimierung des Strömungswiderstandes ermöglicht werden, wobei die Vorrichtung einen einfachen und robusten Aufbau aufweist und eine hohe Energieeffizienz besitzt.

Die Aufgabe wird mit den Merkmalen des Anspruchs 10 gelöst.

Vorteilhafte Weiterbildungen sind in den hiervon abhängigen Unteransprüchen gekennzeichnet.

Erfindungsgemäß werden ein PVD-Verfahren und eine Vorrichtung zur Durchführung des Verfahrens geschaffen. Es wurde herausgefunden, dass das erfindungsgemäße PVD-Verfahren besonders energieeffizient und kostensparend ist. Die benötigte Energie bei anderen Beschichtungsverfahren verteilt sich bei Schmelztauschverzinken, PVD- und einer elektrolytischen Beschichtung entsprechend wie 1 : 10: 100. Somit wird bei dem erfindungsgemäßen PVD-Beschichtungsverfahren zehnmal weniger Energie verbraucht als bei einem elektrolytischen Beschichtungsverfahren.

Das erfindungsgemäße Verfahren und die erfindungsgemäße Vorrichtung dienen dem Beschichten von Substraten, die insbesondere bandförmige Substrate sind. Dieses sind z.B. gewalzte Metallbänder, wie z.B. Stahlbänder. Die Beschichtung erfolgt insbesondere zum Abscheiden von metallischen Schichten auf der Substrat- bzw. Bandoberfläche, wobei es sich bei der metallischen Schicht insbesondere um eine Korrosionsschutzschicht handelt. Die Korrosionsschutzschicht kann dabei eine kathodisch wirksame Schicht, wie z.B. eine Beschichtung aus Zink oder auf der Basis von Zink sein (also aus einem zum Substrat elektrochemisch unedleren Metall) oder eine Barriereschutzschicht sein, z.B. eine Aluminiumschicht oder eine Schicht auf Basis von Aluminium. Aber auch andere metallische Elemente bzw. Kombinationen der genannten Schichten mit den genannten metallischen Elementen, insbesondere Magnesium, Nickel, Chrom, Silizium und deren Legierungen, können abgeschieden werden. Hinsichtlich des Korrosionsschutzes können beispielsweise Schichtkombinationen aus Zink, Magnesium und Aluminium Anwendung finden.

Insbesondere betreffen das Verfahren und die Vorrichtung eine Bandbeschichtung, die im Durchlauf erfolgt und insbesondere inline in einen Verarbeitungsprozess eines Metallbandes, bevorzugt eines Stahlbandes, integriert sein kann. Hiermit wird eine kontinuierliche Beschichtung eines Substrats, insbesondere eines bandförmigen Substrats, ermöglicht.

Die Erfinder haben erkannt, dass die Anforderungen an innovative Beschichtungsvorrichtungen und insbesondere an Klappensysteme in der Einstellung der Schichtdicke auf der Ober- und Unterseite des Substrates, einer hohen Gleichmäßigkeit der Schicht und in einem geringen Strömungswiderstand bei unterschiedlicher Bandbreite bestehen.

Erfindungsgemäß wurde erkannt, dass ein erheblicher Einfluss des Reflexionsverhaltens der Oberflächen der Beschichtungskammer und der Klappen auf den Widerstand der Gasströmung und die Schichtdicke an dem Substrat besteht. Durch Optimierung der Anstellwinkel an dem Klappensystem sowie Anpassung der Klappen gelingt es, homogene Strömungswiderstände bzw. homogene Strömungen und damit Schichtdicken, insbesondere bei unterschiedlichen Bandbreiten zu erzeugen. Unterschiedliche Bandbreiten können dann vorliegen, wenn entweder das Band über die Bandlänge unterschiedliche Breiten aufweist - dies ist der seltenere Fall - oder nach dem Durchlauf eines gesamten Coils (gespulten Metallbands) mit einer bestimmten Bandbreite das nächste Coil eine andere, davon unterschiedliche Bandbreite aufweist. Dies kann in der Produktion sehr häufig der Fall sein und ein Verfahren welches bzw. Vorrichtung welche diese Umstellung bzw. Anpassung auf eine vorgegebene Bandbreite einfach und robust ermöglicht, ist produktionstechnisch vorteilhaft.

Nach der Erfindung werden somit einteilige oder mehrteilige Klappen als Strömungshindernisse verwendet. Klappen im Sinne der Erfindung sind daher nicht als binäres System (offen oder geschlossen) zu interpretieren, sondern im Sinne einer Leiteinrichtung wirken sie als Leitflügel.

Hierbei wird durch eine an die Substratbreite und gewünschter Schichtdicke angepasste Klappenkonfiguration ein geringer Strömungswiderstand eingestellt, sodass der Druckverlust beim Durchgang durch die Klappen viel geringer als bei konventionellen PVD-Beschichtungssystemen ist. Die im System auftretenden Gasdrücke sind hierdurch wesentlich geringer als beispielswese bei einer auf Düsen-basierten Beschichtungsanlage.

Üblicherweise sind bei industrieller Produktion möglichst homogene Schichtdicken über die Substratbreite und Substratlänge sowie Ober- und Unterseite gewünscht, bspw. 3 $\mu$m Schichtdicke an Zink auf dem Stahlband auf der Ober- und Unterseite des Stahlbands. Durch die Erfindung ist es jedoch auch möglich gezielt durch die Leiteinrichtung die Schichtdickenverteilung so zu regeln, dass bspw. die Schichtdicke auf der Oberseite des Substrats 5 $\mu$m aufweist und auf der Unterseite 1 $\mu$m (oder umgekehrt). Gleichermaßen ist auch eine annähernd stufige Verteilung der Schichtdicke über die Substratbreite möglich, wobei die minimale Breite einer "Stufe" durch die Anzahl und Länge der Klappenflügel bestimmt werden kann.

Die Steuerung des Dampfdruckes erfolgt durch die Regulierung des Strömungswiderstands, welcher durch die Einstellung der Klappenanstellwinkel verändert werden kann.

Der Dampfdruck $p(T)$ wird nach der Clausius-Clapeyron-Gleichung aus der Verdampfungsenthalpie $\Delta H$ und der universellen Gaskonstante R für eine bestimmte Temperatur $T$ berechnet:

$$(1) \quad ln\frac{p(T)}{p_1} = \frac{\Delta H}{R}\left(\frac{1}{T_1} - \frac{1}{T}\right)$$

Durch die Einstellung des Dampfdrucks lässt sich die Abscheidungsrate rsteuern, welche unter Berücksichtigung der 1-dimensionalen Maxwell-Bolzmann-Verteilung für einen Dampf mit der Molmasse M berechnet wird:

$$(2) \qquad r = p \left( \frac{M}{2\pi RT} \right)^{1/2}$$

Für die Partikeldichte $\rho$ gilt:

$$(3) \qquad \rho = \frac{pM}{RT}$$

Soll das Substrat mit einer Rate (Masse/Fläche/Zeit) von $r$ beschichtet werden, so gilt für die Strömungsgeschwindigkeit $v$:

$$(4) \qquad v = \frac{r}{\rho} = \left( \frac{RT}{2\pi M} \right)^{1/2}$$

Nach der Änderung der Klappenanstellwinkel ändert sich der Strömungszustand. Die Differenz $D$ vom alten zum neuen stationären Strömungszustand nimmt gemäß $D = e^{-\frac{t}{\tau}}$, mit einer Zeitkonstante $\tau$ ab, welche Auskunft darüber gibt, wie lange es dauert, bis eine Beschichtungskammer mit einem Volumen Vgefüllt wird:

$$(5) \quad \frac{p.M}{R.T} V = A.\rho.v.\tau$$

Aus den obigen Beziehungen ergibt sich die Zeitkonstante $\tau$:

$$(6) \quad \tau = \frac{V}{A} \left( 2\pi \frac{M}{RT} \right)^{1/2}$$

Hierbei ist beispielsweise die Zeitkonstante $\tau$ für ein Kammervolumen von 20 m³ und einer Verdampferfläche von 4 m² bei 500 °C ca. 0,04 s. Soll der stationäre Zustand zu 99 % erreicht sein, ist dafür die Zeit t nötig, welche in diesem Fall 0,2 s beträgt:

$$(7) \quad t = -\tau. \ln(0,01)$$

Während des Beschichtungsvorgangs wird die anfängliche Klappenkonfiguration gemäß einer numerischen Simulation der PVD-Beschichtung eingestellt. Die gewünschten Mittelwerte der Schichtdicke auf der Ober- und Unterseite des Substrats werden hierbei als $D_{OS}$ und $D_{US}$ gekennzeichnet. Während der Beschichtung werden Schichtdickenmessungen durchgeführt. Sobald die Mittelwerte einer traversierenden Messung nach der Beschichtungskammer mit dos und dus vorliegen, wird zuerst die Bandgeschwindigkeit v und/oder die Verdampferleistung P auf v' und P' angepasst, wobei entweder v oder P oder beide variiert werden können gemäß:

$$(8) \qquad \frac{P}{v} \rightarrow \frac{P\prime}{v\prime} = \frac{P}{v} \cdot \frac{D_{OS}+D_{US}}{d_{OS}+d_{US}}$$

Im nächsten Schritt werden die lokalen Abweichungen zwischen den gewünschten Schichtdicken $D_{OS}(y)$ und/oder $D_{US}(y)$ und den gemessenen Schichtdicken dos(y) und dus(y) behandelt. Hierfür wird die folgende Beziehung angewandt (BB bezeichnet dabei die Bandbreite):

(9)

$$\max_{OS,US} \max_{0 \leq y \leq BB} \left\{ \left| 1 - \frac{D_{OS}(y)}{d_{OS}(y)} \right|, \left| 1 - \frac{D_{US}(y)}{d_{US}(y)} \right| \right\} \leq \max_{OS,US} \left\{ \left| 1 - \frac{D_{OS}(y_{max})}{d_{OS}(y_{max})} \right|, \left| 1 - \frac{D_{US}(y_{max})}{d_{US}(y_{max})} \right| \right\}$$

wobei $y_{max}$ jene Stelle ist, bei welcher auf der Ober- und/oder Unterseite des Substarts abhängig von der Position y eine relative Abweichung zwischen gemessener und gewünschter Schichtdicke vorliegt und ihr Maximum bzw. ihren maximal möglichen Wert aufweist.

Befindet sich beispielsweise die Stelle $y_{max}$ auf der Unterseite des Substrats, werden zuerst sämtliche Klappenwinkel $a_i$ mit den Öffnungsbreiten $b_i$ gemäß ihren Abständen maxi zur Klappe i korrigiert:

$$(10) \quad b_i \rightarrow b_i' = b_i \cdot \left(\frac{d_{US}(y_{max})}{D_{US}(y_{max})}\right)^{\left(\frac{a}{max_i}\right)^n}$$

wobei a der kleinste Abstand zwischen Substrat und der substratnächsten Drehachse der Klappe ist.

Befindet sich die Stelle $y_{max}$ hingegen auf der Oberseite des Substrats, werden zuerst auf der Oberseite sämtliche Klappenwinkel $\alpha_i$ mit den Öffnungsbreiten $b_i$ gemäß ihren Abständen $max_i$ zur Klappe i verstellt:

$$(11) \quad b_i \rightarrow b_i' = b_i \cdot \left(\frac{d_{OS}(y_{max})}{D_{OS}(y_{max})}\right)^{\left(\frac{a}{max_i}\right)^n}$$

Der Exponent n mit 1 <= n <= 3 ist hierbei fest und wird durch Erfahrung so optimiert, dass der beschriebene iterative Algorithmus mit möglichst wenigen Iterationen zur gewünschten Schichtdicke führt.

Um ein unnötiges Verstellen der Klappen zu vermeiden, werden die Klappenwinkel nicht mehr verändert, sobald die relative Abweichung zwischen gewünschter und gemessener Schichtdicke einen Grenzwert unterschritten hat. Der Grenzwert, bei welchem die Klappenanstellung nicht mehr geändert wird, kann beispielsweise bei einer Abweichung von insgesamt (also beidseitig) weniger als 10 % bevorzugt geringer als 5 % gewählt werden.

Somit betrifft die Erfindung ein PVD-Verfahren zum Abscheiden von metallischen Schichten aus einer Dampfphase auf ein metallisches Substrat, insbesondere auf Substraten mit unterschiedlicher Bandbreite, wobei in einer Beschichtungseinheit mindestens ein Verdampfer und ein Substrat vorhanden sind und zwischen dem Verdampfer und dem Substrat ein Strömungsweg für die Beschichtungspartikel besteht, wobei im Strömungsweg mindestens eine Klappe pro Substratseite vorhanden ist, welche um eine Drehachse zur Beeinflussung des Strömungswiderstands drehbar angeordnet ist, wobei die Drehachse parallel zur Substratebene und vorzugsweise längs zur Transportrichtung des Substrats verläuft.

Es ist vorteilhaft, wenn die Klappen einen Klappenanstellwinkel besitzen, welcher mittels einer Verstelleinrichtung verstellbar ist, sodass die Klappen unabhängig voneinander verstellbar sind.

Zudem ist es vorteilhaft, wenn die Klappen in Verbindung mit beidseitig angeordneten, seitlichen Blenden wirken.

Vorteilhafterweise sind die seitlichen Blenden einteilig oder mehrteilig ausgebildet und mittels einer Verschiebeinrichtung zur Adaptierung an die jeweilige Substratbreite verschiebbar.

In einer vorteilhaften Ausführungsform bilden die Klappen ein Monoklappen- (8) oder ein Multiklappensystem oder ein kombiniertes Klappensystem.

In einer besonders vorteilhaften Ausführungsform weisen die Klappen Klappenflügel auf, welche in ihrer Länge und/oder Höhe und/oder Breite variieren, wobei eine alternierende Klappenanordnung mit unterschiedlich langen Klappenflügeln eingestellt wird.

Hierbei kann besonders vorteilhaft eine Anordnung gewählt werden, bei welcher die Klappenflügellänge am Substratrand kürzer ist, insbesondere zum Substratrand hin stetig abnimmt. Die Klappenflügel können die Schichtdickenverteilung beeinflussen wobei längere Klappenflügel ein höheres Hindernis darstellen als kürzere Klappenflügel.

Es ist erfindungsgemäß, wenn die Klappen von einer Symmetrieachse weg zum Substratrand hin symmetrisch angeordnet sind, sodass der Klappenanstellwinkel zum Substratrand hin stetig abnimmt.

Es ist ebenfalls vorteilhaft, wenn der Klappenanstellwinkel an korrespondierenden Klappen der verdampfernahen Seite des Substrats größer eingestellt wird als an der zugehörigen, über das Substrat gespiegelten Klappe an der verdampferfernen Seite des Substrats. Vorteilhafterweise sind jene Klappen deren Drehachse weiter von der Symmetrieebene entfernt als die halbe Bandbreite, wobei der Klappenanstellwinkel derart eingestellt ist, dass die Klappenflügel direkt auf die nächstliegende Substratkante zeigen.

In einer vorteilhaften Ausführungsform wird nach einem Beschichtungsvorgang die abgeschiedene Schichtdicke in einer Messeinheit gemessen, wobei die Verstelleinrichtung in Verbindung mit der Messeinheit wirkt und die Einstellung des Klappenanstellwinkels in Abhängigkeit der Messergebnisse erfolgt.

In einer weiterhin vorteilhaften Ausführungsform wird in dem Verfahren ein bandförmiges Substrat durchlaufend beschichtet.

Eine Ausführungsform sieht vor, dass das bandförmige Substrat während der Beschichtung horizontal oder vertikal geführt wird.

Eine Ausführungsform sieht vor, dass bei einer vertikalen Bandführung die gegenüberliegenden Klappen beidseitig des Substrates spiegelsymetrisch angestellt werden. Diese Einstellung hat den Vorteil, dass hierdurch eine homogene Schichtdicke auf beiden Substratseiten erzeugt werden kann.

Eine Ausführungsform sieht vor, dass bei horizontaler Bandführung die gegenüberliegenden Klappen beidseitig des Substrates unterschiedlich angestellt werden. Bei einer Anordnung welche den Verdampfer näher zur der Substratunterseite als zur Substratoberseite positioniert vorsieht, stellt sich ohne jegliche Regelung in etwa ein Verhältnis der Schichtdicken der Substratoberseite zur Substratunterseite von 1 : 1,8 ein, dies bedeutet, dass auf der Substratunterseite eine fast doppelt so dicke Schicht sich einstellen würde. Daher kann vorteilhafterweise der Klappenanstellwinkel an der verdampfernahen Seite des Substrats größer eingestellt werden, als jener auf der verdampferfernen Seite, insbesondere um mindestens 10° größer.

Vorteilhafterweise ist das Substrat ein Metallband, insbesondere ein Stahlband und als Beschichtung wird eine metallische Korrosionsschutzschicht bevorzugt auf Basis von Zink abgeschieden.

Die Erfindung betrifft ebenfalls eine Vorrichtung zum PVD-Beschichten von metallischen Substraten, insbesondere von Substraten mit unterschiedlicher Substratbreite, insbesondere nach einem Verfahren nach einem der vorhergehenden Ansprüche, wobei in einer Beschichtungseinheit, die insbesondere als Beschichtungskammer ausgebildet ist, mindestens ein Verdampfer vorhanden ist und zwischen dem Verdampfer und einem durch die Beschichtungseinrichtung führbaren Substrat ein Strömungsweg für die Beschichtungspartikel besteht, wobei im Strömungsweg mindestens eine Klappe pro Substratseite vorhanden ist, welche um eine Drehachse zur Beeinflussung des Strömungswiderstands drehbar angeordnet ist, wobei die Drehachse parallel zur Substratebene und vorzugsweise längs zur Transportrichtung des Substrats verläuft.

Es ist vorteilhaft, wenn die Klappen einen Klappenanstellwinkel besitzen, welcher mittels einer Verstelleinrichtung verstellbar ist, sodass die Klappen unabhängig voneinander verstellbar sind.

Zudem ist es vorteilhaft, wenn zusätzlich zu den Klappen zwei seitliche Blenden, jeweils eine auf beiden Seiten des Substrats, angeordnet sind.

Es ist ebenfalls vorteilhaft, wenn die seitlichen Blenden einteilig oder mehrteilig ausgebildet sind und mittels einer Verschiebeinrichtung zur Adaptierung an die jeweilige Substratbreite verschiebbar sind.

In einer vorteilhaften Ausführungsform ist ein Monoklappen- oder ein Multiklappensystem oder ein kombiniertes Klappensystem in der Beschichtungseinheit vorhanden.

In einer weiterhin vorteilhaften Ausführungsform weisen die Klappen Klappenflügel auf, welche in ihrer Länge und/oder Höhe und/oder Breite variieren, wobei eine alternierende Klappenanordnung mit unterschiedlich langen Klappenflügeln einstellbar ist.

Erfindungsgemäß sind die Klappen von einer Symmetrieachse weg zum Substratrand hin symmetrisch angeordnet und weisen einen Klappenanstellwinkel auf, der zum Substratrand hin stetig abnimmt.

Vorteilhafterweise ist der Klappenanstellwinkel korrespondierender Klappen an der Verdampfer nahen Seite des Substrats größer als der Klappenanstellwinkel der zugehörigen, über das Substrat gespiegelten Klappe an der Verdampfer fernen Seite des Substrats.

Es ist vorteilhaft, wenn bei jenen Klappen deren Drehachse weiter von der Symmetrieebene entfernt sind als die halbe Bandbreite, der Klappenanstellwinkel derart eingestellt ist, sodass die Klappenflügel direkt auf die nächstliegende Bandkante zeigen.

Es ist ebenfalls vorteilhaft, wenn nach der Beschichtungseinheit eine Messeinheit angeordnet ist, welche mit der Verstelleinrichtung der Klappen gekoppelt ist.

Zudem ist es vorteilhaft, wenn die mindestens eine Beschichtungseinheit als Kammer ausgebildet ist mit einer Einlassseite und einer Auslassseite, wobei das Substrat von der Einlassseite zur Auslassseite führbar ist und wobei einlassseitig und auslassseitig je eine Vakuumschleuse vorhanden sind, sodass ein Substrat kontinuierlich durch die Kammer führbar und beschichtbar ist.

Eine Ausführungsform der Vorrichtung sieht vor, dass die Vorrichtung so ausgebildet ist, dass das bandförmige Substrat während der Beschichtung horizontal oder vertikal in der Kammer geführt ist.

Eine Ausführungsform der Vorrichtung sieht vor, dass bei einer vertikalen Bandführung die gegenüberliegenden Klappen beidseitig des Substrates spiegelsymetrisch angestellt sind.

Eine Ausführungsform der Vorrichtung sieht vor, dass bei horizontaler Bandführung die gegenüberliegenden Klappen beidseitig des Substrates unterschiedlich angestellt sind.

Die Erfindung wird anhand einer Zeichnung beispielhaft erläutert. Es zeigen dabei:

Figur 1:   Beschichtungsanlage mit einer horizontalen Substratführung;

Figur 2:   Beschichtungsanlage mit einer horizontalen Substratführung und mehreren nacheinander geschalteten Beschichtungs- und Messeinheiten;

Figur 3: Multiklappensystem angeordnet auf einer Ebene sowie mehrteilige, seitlich verschiebbare Blenden für Beschichtung eines breiten Substrats bei einer horizontalen Substratführung;

Figur 4: Multiklappensystem angeordnet auf einer Ebene sowie mehrteilige, seitlich verschiebbare Blenden für Beschichtung eines schmalen Substrats bei einer horizontalen Substratführung;

Figur 5: Multiklappensystem angeordnet auf einer Kreisbahn sowie mehrteilige, seitlich verschiebbare Blenden für Beschichtung eines breiten Substrats bei einer horizontalen Substratführung;

Figur 6: Multiklappensystem angeordnet auf einer Kreisbahn sowie mehrteilige, seitlich verschiebbare Blenden für Beschichtung eines schmalen Substrats bei einer horizontalen Substratführung;

Figur 7: Monoklappensystem angeordnet auf einer Ebene sowie mehrteilige, seitlich verschiebbare Blenden für Beschichtung eines breiten Substrats bei einer horizontalen Substratführung;

Figur 8: Monoklappensystem angeordnet auf einer Ebene sowie mehrteilige, seitlich verschiebbare Blenden für Beschichtung eines schmalen Substrats bei einer horizontalen Substratführung;

Figur 9: Beschichtungsanlage mit einer vertikalen Substratführung;

Figur 10: Multiklappensystem angeordnet auf einer Ebene sowie mehrteilige, seitlich verschiebbare Blenden für Beschichtung eines breiten Substrats bei einer vertikalen Substratführung;

Figur 11: Multiklappensystem angeordnet auf einer Ebene sowie mehrteilige, seitlich verschiebbare Blenden für Beschichtung eines schmalen Substrats bei einer vertikalen Substratführung

Figur 12: Multiklappensystem angeordnet auf einer Kreisbahn sowie mehrteilige, seitlich verschiebbare Blenden für Beschichtung eines breiten Substrats bei einer vertikalen Substratführung;

Figur 13: Multiklappensystem angeordnet auf einer Kreisbahn sowie mehrteilige, seitlich verschiebbare Blenden für Beschichtung eines schmalen Substrats bei einer vertikalen Substratführung;

Figur 14: Monoklappensystem angeordnet auf einer Ebene sowie mehrteilige, seitlich verschiebbare Blenden für Beschichtung eines breiten Substrats bei einer vertikalen Substratführung;

Figur 15: Monoklappensystem angeordnet auf einer Ebene sowie mehrteilige, seitlich verschiebbare Blenden für Beschichtung eines schmalen Substrats bei einer vertikalen Substratführung;

Figur 16: Klappensystem zeigend die Parameter, welche bei der Einstellung des Klappenanstellwinkels berücksichtigt werden.

Figur 17: beispielhafte Beschichtungsverteilung für eine nicht homogene Zielschichtdickenverteilung.

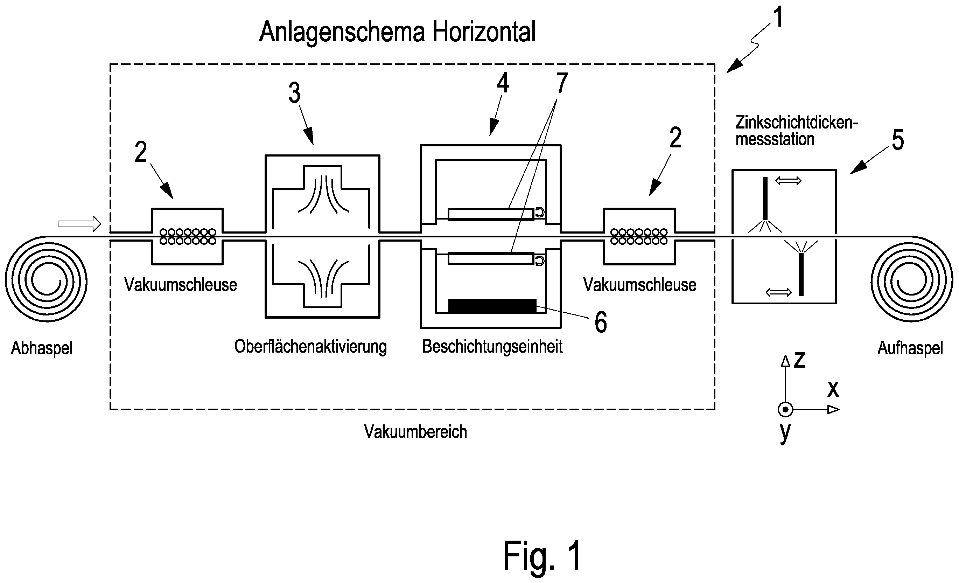

Das erfindungsgemäße Beschichtungsverfahren wird in einer Beschichtungsanlage 1 durchgeführt (Figur 1), wobei die Beschichtungsanlage 1 mindestens zwei Vakuumschleusen 2, mindestens eine Oberflächenaktivierungseinrichtung 3, mindestens eine Beschichtungseinheit 4 und mindestens eine Messeinheit 5 umfasst.

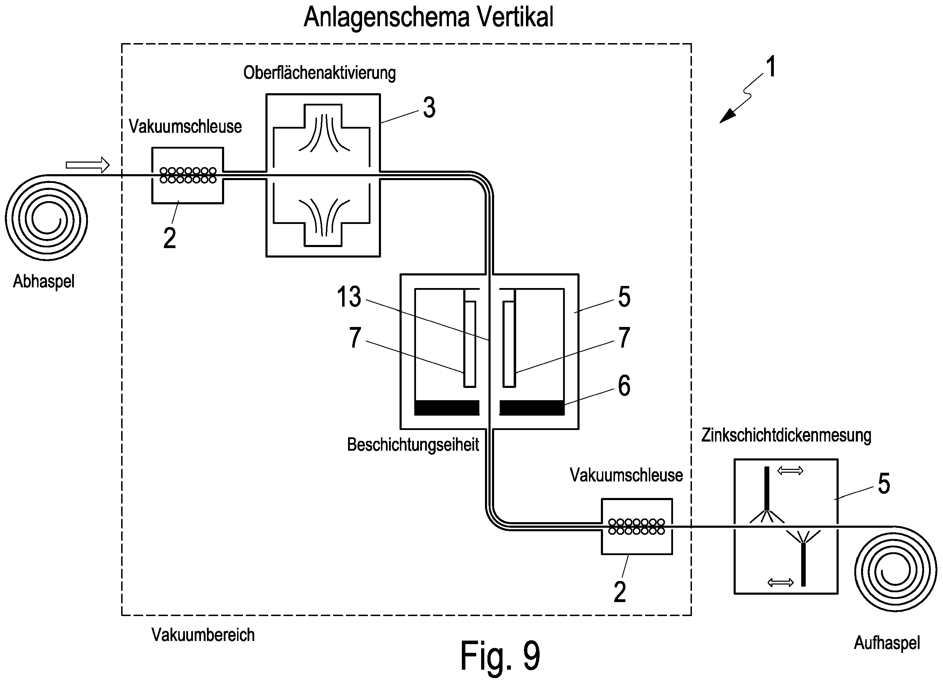

Eine derartige Beschichtungsanlage 1 kann eine horizontale (Figur 1) und/oder eine vertikale (Figur 9) Substratführung aufweisen.

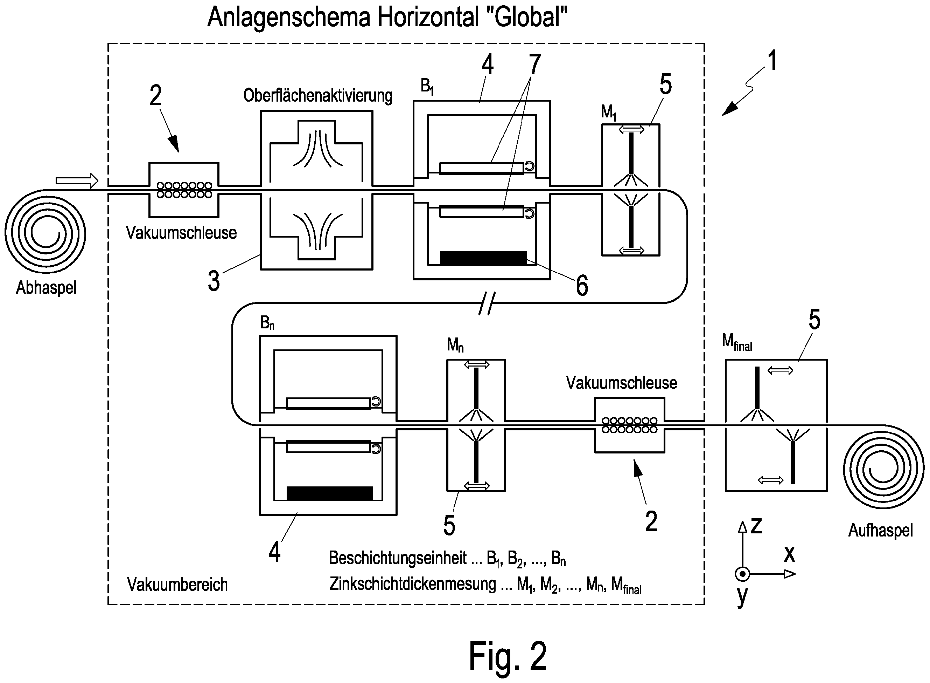

In der Beschichtungsanlage 1 können mehrere hintereinander angeordnete Beschichtungs- 4 und Messeinheiten 5 vorgesehen sein (Figur 2), sodass die Schichtdicke ortsnah gemessen und gegebenenfalls angepasst werden kann. Die Messung der Schichtdicke kann mittels kontaktlosen Messtechniken, beispielsweise Fluoreszenzspektroskopie, durchgeführt werden.

Die Beschichtungseinheit 4 kann wie eine Beschichtungskammer ausgebildet sein, in welcher mindestens ein Verdampfer 6 und ein Klappensystem, welches mehrere Klappen 7 umfasst, zur Steuerung der Dampfströmung sowie des Dampfdruckes vorgesehen sind. Die konventionellen Seitenwände können durch seitliche Blenden ersetzt werden, welche in Verbindung mit den Klappen 7 agieren können. Außerdem umfasst die Beschichtungseinheit 4 mindestens zwei Vakuumschleusen 2 und eine Einlass- und eine Auslassseite, sodass das Substrat kontinuierlich eingeführt und beschichtet werden kann.

Der Verdampfer 6 kann an einer Seite oder an beiden Seiten des zu beschichtenden Substrats 13 angeordnet sein.

Die Klappen 7 können als Monoklappen 8 oder als Multiklappen 9 ausgebildet sein, sodass eine Mehrzahl von Monoklappen 8 ein Monoklappensystem 10 und eine Mehrzahl von Multiklappen 9 ein Multiklappensystem 11 bilden.

Es ist auch eine Mischung beider Systeme möglich, sodass Multiklappen 9 und Monoklappen 8 nebeneinander bestehen.

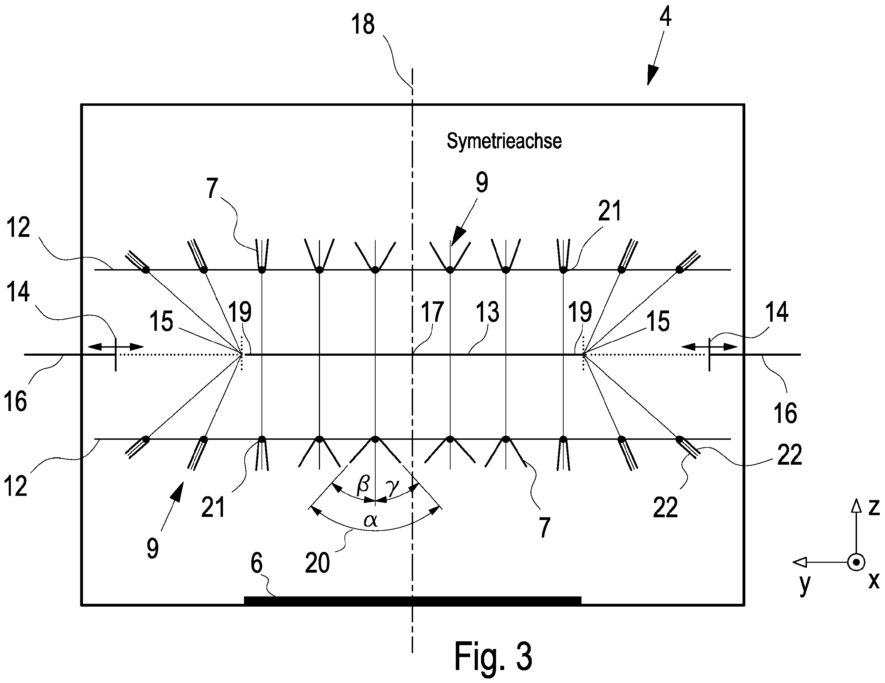

Bei einem Multiklappensystem 11 (Figur 3) sind mindestens zwei Klappenreihen 12 vorgesehen, welche entlang der Förderrichtung des Substrats 13 oder quer zur Förderrichtung des Substrats 13 angeordnet sind. Die Achsen der Klappenreihen 12 können sich in einer parallel zum Substrat 13 verlaufenden Ebene an der Verdampfer nahen Seite des Substrats 13, an der Verdampfer fernen Seite des Substrats 13 oder an beiden Seiten des Substrats 13 befinden. In der Beschichtungseinheit 4 können einteilige oder mehrteilige seitliche Blenden 14 vorgesehen sein, welche zur Substratkante 15 hin zeigen und mittels einer oder mehreren Verschiebeinrichtungen 16 verschiebbar sind. Die Verschiebeinrichtung 16 kann wie ein Tragarm ausgebildet sein.

Die Quermitte 17 des Substrats 13 weist eine imaginäre Symmetrieachse 18 auf, welche quer zur Transportrichtung des Substrats 13 verläuft. Die Klappen 7 sind von der Symmetrieachse 18 weg zum Substratrand 19 hin symmetrisch angeordnet, sodass der Klappenanstellwinkel 20 zum Substratrand 19 hin symmetrisch um eine bestimmte Winkelgröße abnimmt.

Die Bezugsgröße für den Klappenanstellwinkel 20 ist die von den Achsen aller Wellen 21 der Klappen 7 auf der Substratseite aufgespannte Ebene.

Die Abnahme der Klappenanstellwinkel 20 wird stetig zum Substratrand 19 hin kleiner, wobei der Öffnungswinkel jener Klappe 7 welche am nächsten zur Symmetrieachse 18 angeordnet ist beispielsweise 125° beträgt. Bei einer Anordnung mit 4 Klappen 7 je Quadrant des Kammerquerschnitts könnten die Öffnungswinkel von der Symmetrieachse 18 weg folgende Werte aufweisen: 125°, 90°, 60°, 35°. In diesem Fall beträgt also die Winkeländerung 35°, 30° und 25° und nimmt daher zum Rand hin ab. Seien allgemein die Klappenanstellwinkel von der Symmetrieachse zum Rand hin aufsteigend mit $w_1$, $w_2$, $w_3$,..., $w_n$ bezeichnet, dann sollen bevorzugt ($w_{i+1}$- $w_i$) kleiner ($w_i$- $w_{i-1}$) sein und alle ($w_{i+1}$- $w_i$) größer 5 °, aber kleiner als (200 / n) °, damit bis zum Rand hin eine möglichst konstante Schichtdicke erzielt wird.

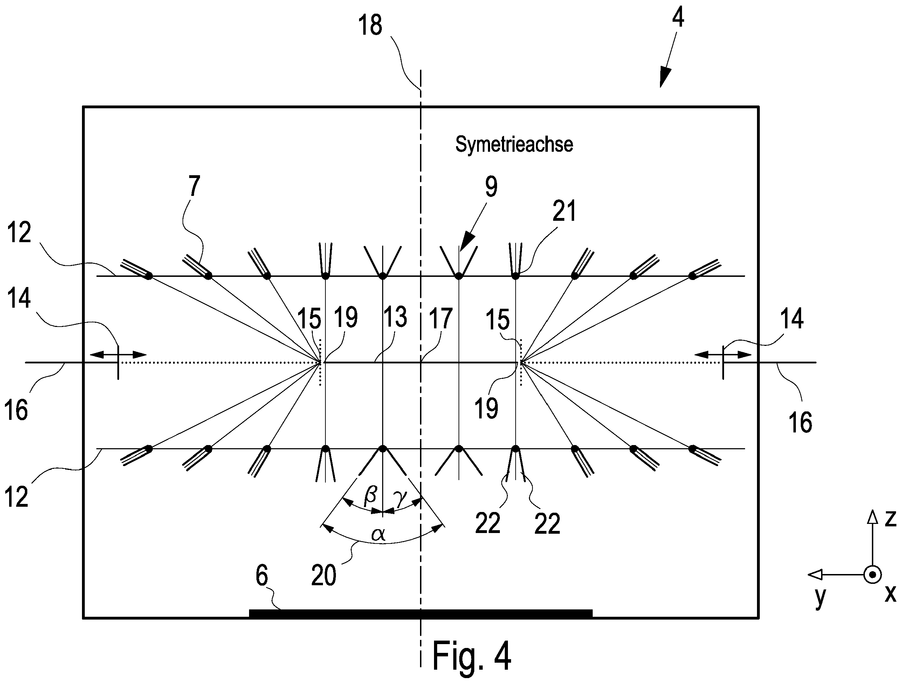

Der Klappenanstellwinkel 20 ist abhängig von der Substratbreite und der gewünschten Schichtdicke variabel verstellbar. Der Klappenanstellwinkel 20 der zum Substratrand 19 hin zeigenden Klappen 7 nimmt mit der abnehmenden Substratbreite ab. Jene Klappen welche, außerhalb des Substrats 13 angeordnet sind, also jene Klappen 7 deren Drehachse weiter von der Symmetrieebene 18 entfernt sind als die halbe Substratbreite, können bevorzugt einen Klappenanstellwinkel 20 aufweisen, sodass die Klappenflügel 22 direkt auf die nächstliegende Substratkante 15 zeigen. So besitzen die zum Substratrand 19 hin zeigenden Klappen 7 bei einem schmalen Substrat 13 einen kleineren Klappenanstellwinkel 20 als bei einem breiten Substrat 13 (Figur 4). Der Öffnungswinkel dieser Klappenflügel 22 beträgt bevorzugt 0°, d.h. keine Öffnung. Diese Einstellung kann die Schichtdicke am Rand des Substrats 13 erhöhen, da der Widerstand gegenüber der Strömung durch diese Einstellung minimiert werden kann.

Außerdem ist der Klappenanstellwinkel 20 größer im Bereich der Quermitte 17 des Substrats 13 und nimmt zum Substratrand 19 hin ab.

Ferner wird an der verdampfernahen Seite des Substrats 13 ein größerer Klappenanstellwinkel 20 eingestellt als an der verdampferfernen Seite des Substrats 13.

Für die Verstellung des Klappenanstellwinkels 20 ist es vorgesehen, in einer Beschichtungseinheit 4 Wellen 21 anzuordnen, welche die Klappen 7 tragen. Die Wellen 21 können entlang der Förderrichtung des Substrats 13 oder quer zur Förderrichtung des Substrats 13 angeordnet sein. Vorzugsweise sind die Wellen 21 entlang der Förderrichtung des Substrats 13 angeordnet und durchgreifen die gesamte Beschichtungseinheit 4. Die entsprechenden Klappen 7 sind mit einer Längskante an der Welle 21, welche einer imaginären Drehachse entspricht, drehbar angeordnet und können so bezüglich ihres Anstellwinkels 20 zum Substrat 13 eingestellt werden. Die Drehachse verläuft parallel zur Substratebene und kann quer oder längs zur Transportrichtung des Substrats verlaufen. Eine Anordnung längs zur Transportrichtung kann konstruktive Vorteile für die Vorrichtung aufweisen als auch vorteilhafterweise die Homogenität der Schichtdicke über die Substratbreite weiter erhöhen. Auch kann eine Variierung der Längsausrichtung um 5 bis 45 ° möglich sein, wobei eine Abweichung von plus/minus 5° noch als im Wesentlichen längs zur Transportrichtung interpretiert wird. Die Abweichung von mehr als 5° also eine bewusste "Schrägeinstellung" der Drehachse in Bezug auf die Transportrichtung kann eine alternative Ausführungsform darstellen, welche allerdings konstruktiv herausfordernder sein kann. Bei einer Anordnung quer zur Transportrichtung können die Klappenflügel 22 mehrteilig ausgeführt sein um eine Beeinflussung der Homogenität der Schichtdicke über die Bandbreite des Substrats 13 realisieren zu können.

Stehen die Klappen 7 senkrecht zur Ebene des Substrats 13 wird entsprechend ein geringerer Widerstand der Strömung entgegen gesetzt. Die Klappen 7 können von den Wellen 21 weg eine Erstreckung besitzen, die so groß ist, dass bei Klappen 7 die in der Ebene des Substrats 13 angeordnet sind, die freien Längskanten der Klappe 7 an der jeweils nächsten Welle 21 anliegen oder diese leicht überlappen, sodass bestimmte Bereiche auch gegen die Strömung gesperrt werden können (z.B. bei Substratstillstand). Die Verstellung des Klappenanstellwinkels 20 erfolgt mittels einer Verstelleinrichtung 23, welche sich außerhalb der Beschichtungseinheit 4 befinden kann. Es ist vorteilhaft, wenn jede Klappe 7 ihre eigene Verstelleinrichtung 23 besitzt.

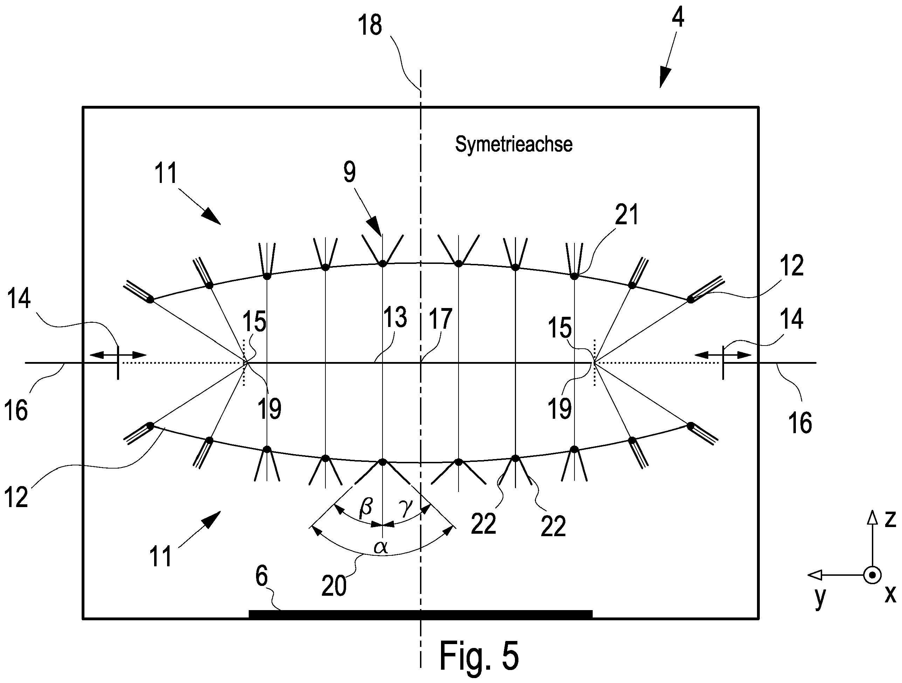

Bei einer weiteren Ausführungsform können die Klappenreihen 12 auf einer imaginären Kreisbahn, Parabel oder Ellipse angeordnet sein (Figur 5). Auch bei einer derartigen Klappenkonfiguration nehmen die Klappenanstellwinkel 20 von der Symmetrieachse 18 weg zum Substratrand 19 hin in geregelten Winkelgrößen ab. Das bedeutet, dass die entsprechenden Werte vorbestimmt sind bzw. vorgegeben werden.

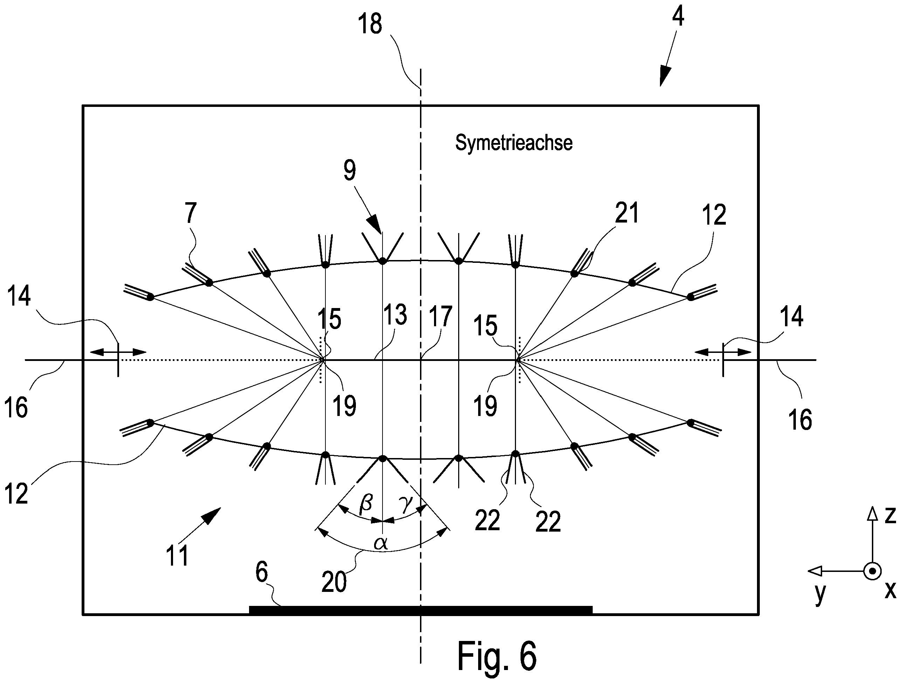

Zudem nimmt der Klappenanstellwinkel 20 der zum Substratrand 19 hin zeigenden Klappen 7 mit der abnehmenden Substratbreite ab. So besitzen die zum Substratrand 19 hin zeigenden Klappen 7 bei einem schmalen Substrat 13 einen kleineren Klappenanstellwinkel 20 als bei einem breiten Substrat 13 (Figur 6).

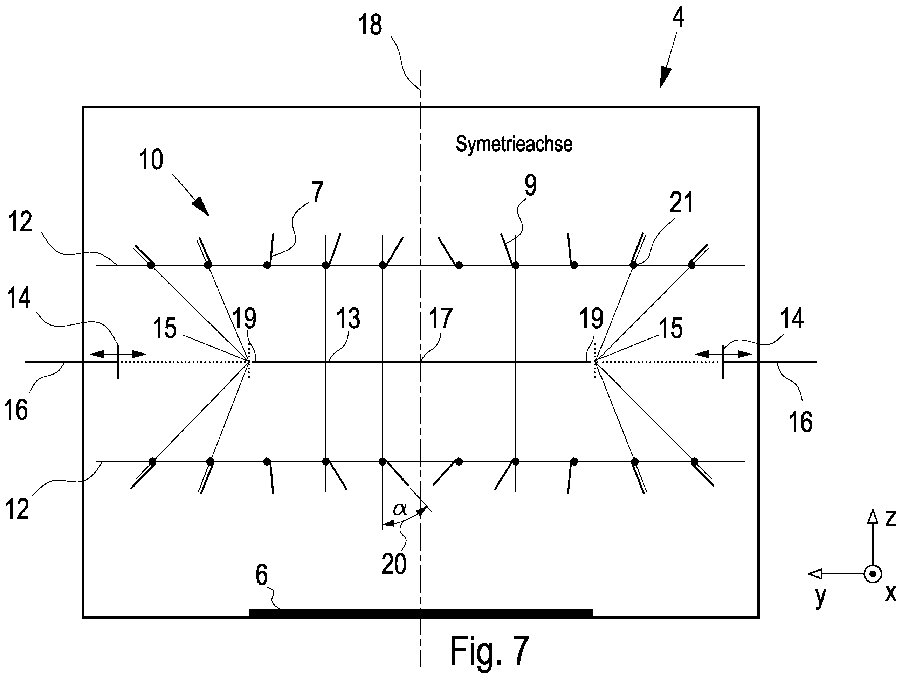

Bei einer weiteren vorteilhaften Ausführungsform kann das Klappensystem als ein Monoklappensystem 10 ausgebildet sein (Figur 7). In einem derartigen Monoklappensystem 10 sind ebenfalls mindestens zwei Klappenreihen 12 vorgesehen, welche entlang der Förderrichtung des Substrats 13 oder quer zur Förderrichtung des Substrats 13 angeordnet sind. Die Klappenreihen 12 können sich auf einer parallel zum Substrat 13 verlaufenden Ebene an der verdampfernahen Seite des Substrats 13, an der verdampferfernen Seite des Substrats 13 oder an beiden Seiten des Substrats 13 befinden.

In dem Monoklappensystem 10 können die Klappenreihen 12 auch auf einer imaginären Kreisbahn, Parabel oder Ellipse angeordnet sein. Unabhängig davon, ob die Klappenreihen sich auf einer Ebene oder auf einer imaginären Kreisbahn, Parabel oder Ellipse befinden, sind die Klappen 7 von der Symmetrieachse 18 weg zum Substrat 13 hin symmetrisch angeordnet und der Klappenanstellwinkel 20 nimmt symmetrisch zum Substratrand 19 hin um eine bestimmte Winkelgröße ab.

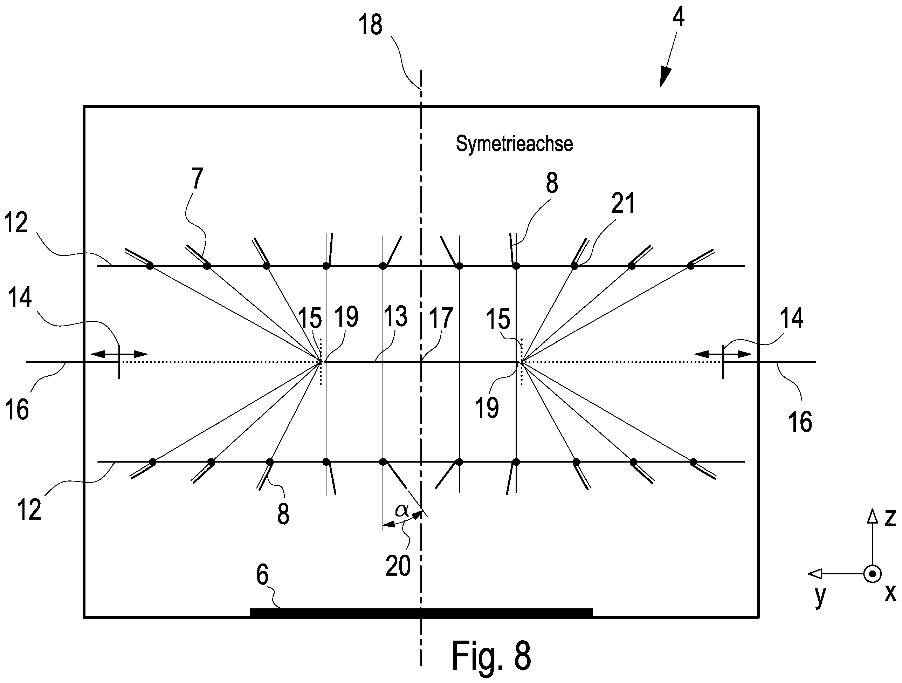

Bei einem breiten Substrat 13 ist der Klappenanstellwinkel 20 größer als bei einem schmalen Substrat 13 (Figur 8).

Eine andere Ausführungsform sieht eine Beschichtungsanlage 1 mit einer vertikalen Substratführung vor (Figur 9).

Auch bei einer vertikalen Substratführung umfasst die Beschichtungsanlage 1 mindestens zwei Vakuumschleusen 2, mindestens eine Oberflächenaktivierungseinrichtung 3, mindestens eine Beschichtungseinheit 4 und mindestens eine Messeinheit 5.

Die Beschichtungseinheit 4 kann wie eine Beschichtungskammer ausgebildet sein, in welcher mindestens ein Verdampfer 6 und ein Klappensystem, welches mehrere Klappen 7 umfasst, zur Steuerung der Dampfströmung sowie des Dampfdruckes vorgesehen sind. Die konventionellen Seitenwände können durch seitliche Blenden ersetzt werden, welche in Verbindung mit den Klappen 7 agieren können. Außerdem umfasst die Beschichtungseinheit 4 mindestens zwei Vakuumschleusen 2 und eine Einlass- und eine Auslassseite, sodass das Substrat 13 kontinuierlich vertikal eingeführt und beschichtet werden kann.

Der Verdampfer 6 kann an einer Seite oder an beiden Seiten des zu beschichtenden Substrats 13 angeordnet sein.

Die Klappen 7 können als Monoklappen 8 oder als Multiklappen 9 ausgebildet sein, sodass eine Mehrzahl von Monoklappen 8 ein Monoklappensystem 10 und eine Mehrzahl von Multiklappen 9 ein Multiklappensystem 11 bilden.

Selbstverständlich ist auch eine Mischung beider Systeme möglich, sodass Multiklappen 9 und Monoklappen 8 nebeneinander bestehen.

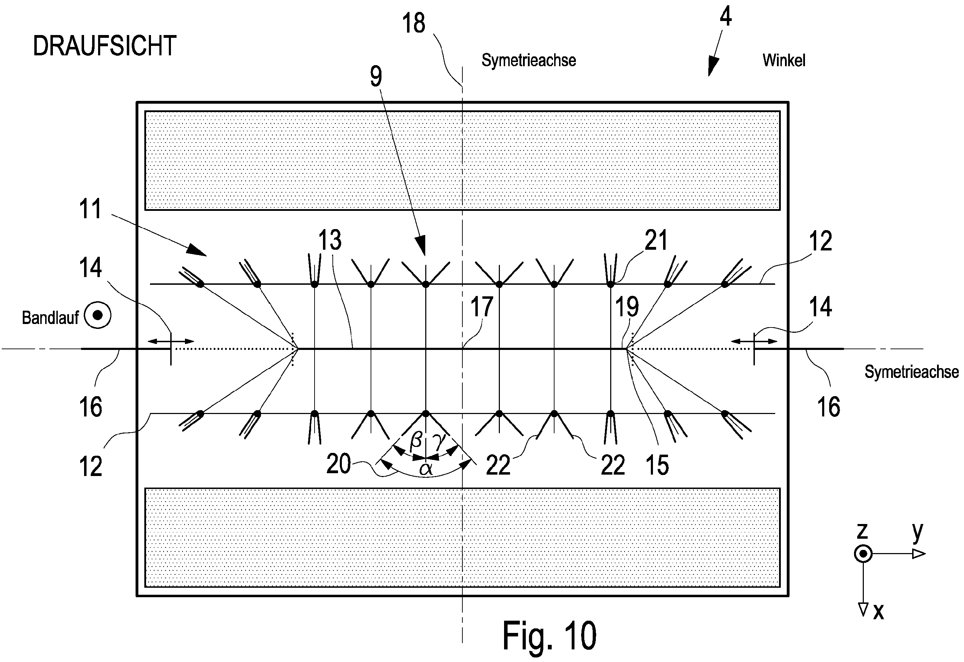

Bei einer vertikalen Substratführung wird das Substrat 13 vertikal entlang der Z-Achse in die Beschichtungseinheit 4 eingeführt. In einer Ausführungsform sind in der Beschichtungseinheit 4 zwei Klappenreihen 12 vorgesehen, die beidseitig vom Substrat 13 auf einer parallel zum Substrat 13 verlaufenden Ebene angeordnet sind. Jede Klappenreihe 12 umfasst zehn Multiklappen 10, welche von der Symmetrieachse 18 weg einen abnehmenden Klappenanstellwinkel 20 aufweisen. Die Abnahme des Klappenanstellwinkels 20 ist von der Substratbreite und der gewünschten Schichtdicke abhängig. Daher ist sie bei einem breiten Substrat 13 langsamer als bei einem schmalen Substrat 13 (Figur 10).

Für eine bessere Steuerung der Dampfströmung sowie des Dampfdruckes wirkt ein derartiges Multiklappensystem 10 in Kombination mit seitlichen Blenden 14, welche einteilig oder mehrteilig ausgebildet sein können. Die seitlichen Blenden 14 sind beispielsweise mittig und/oder außenmittig drehbar angeordnet. Sie sind in ihrem Winkel verstellbar und können horizontal und/oder lateral verschiebbar ausgeführt werden. Die laterale Verschiebung der seitlichen Blenden 14 wird mittels einer Verschiebeinrichtung 16 ausgeführt.

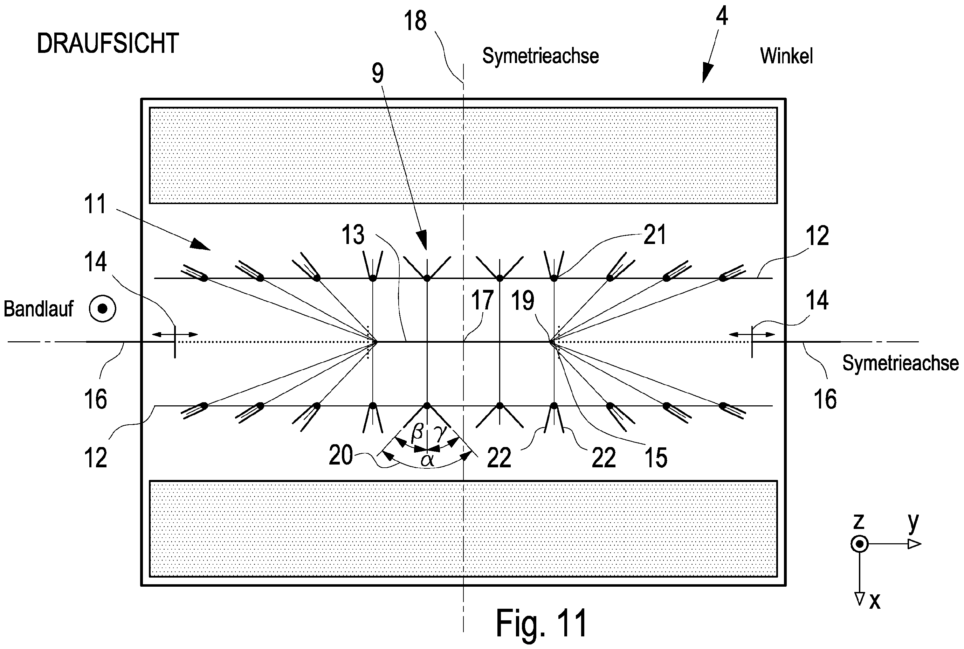

Die Abnahme des Klappenanstellwinkels 20 ist bei einem schmalen Substrat 13 größer, insbesondere bei den radial zum Substratrand 19 hin stehenden Klappen 7 (Figur 11). Der Öffnungswinkel dieser Multiklappen 9 beträgt bevorzugt 0°, d.h. keine Öffnung. Diese Einstellung kann die Schichtdicke am Rand des Substrats 13 erhöhen, da der Widerstand gegenüber der Strömung durch diese Einstellung minimiert werden kann.

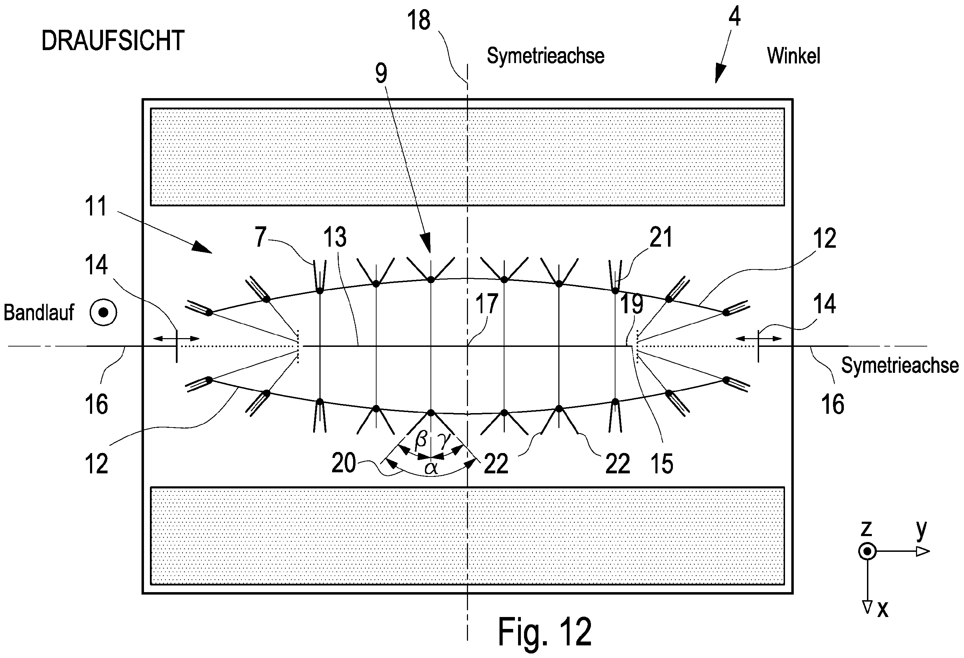

In einer anderen Ausführungsform können die Klappenreihen 12 auf einer imaginären Kreisbahn, Parabel oder Ellipse angeordnet sein. Es sind zwei Klappenreihen 12 vorgesehen und jede Klappenreihe 12 kann jeweils zehn Multiklappen 9 umfassen, welche aus jeweils zwei Klappenflügel 22 ausgebildet sind. Die Klappenflügel 22 sind auf einer Welle 21 drehbar angeordnet (Figur 12).

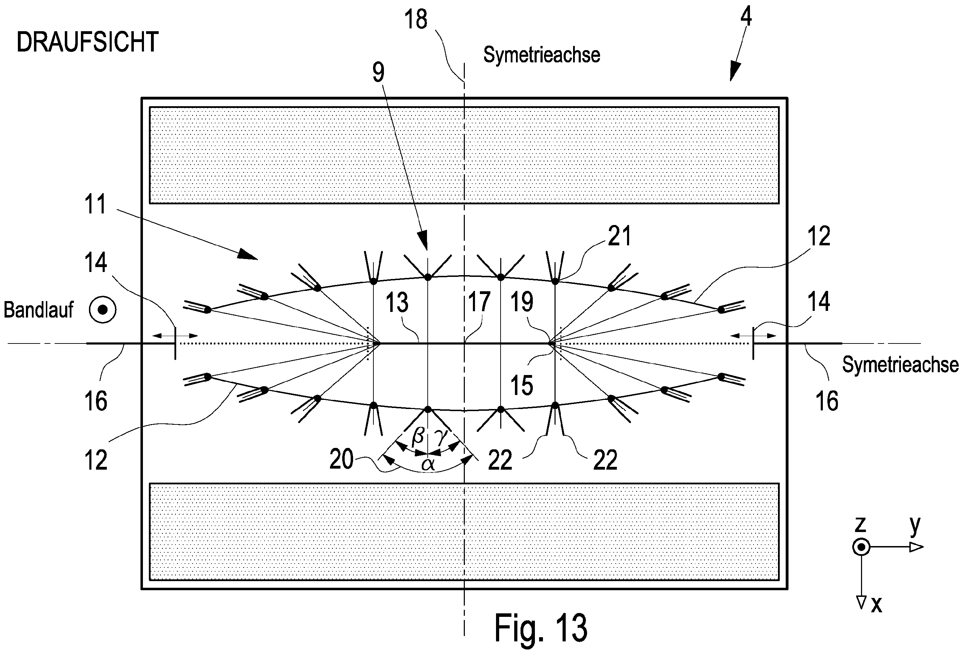

Das Substrat 13 wird vertikal entlang der Z-Achse in die Beschichtungseinheit 4 eingeführt. Die Klappenreihen 12 sind beidseitig vom Substrat 13 angeordnet. Der Klappenanstellwinkel 20 ist größer im Bereich der Quermitte 17 des Substrats 13 und nimmt zum Substratrand 19 hin ab. Bei einem breiten Substrat 13 ist die Abnahme der Klappenanstellwinkel 20 langsamer als bei einem schmalen Substrat 13 (Figur 13).

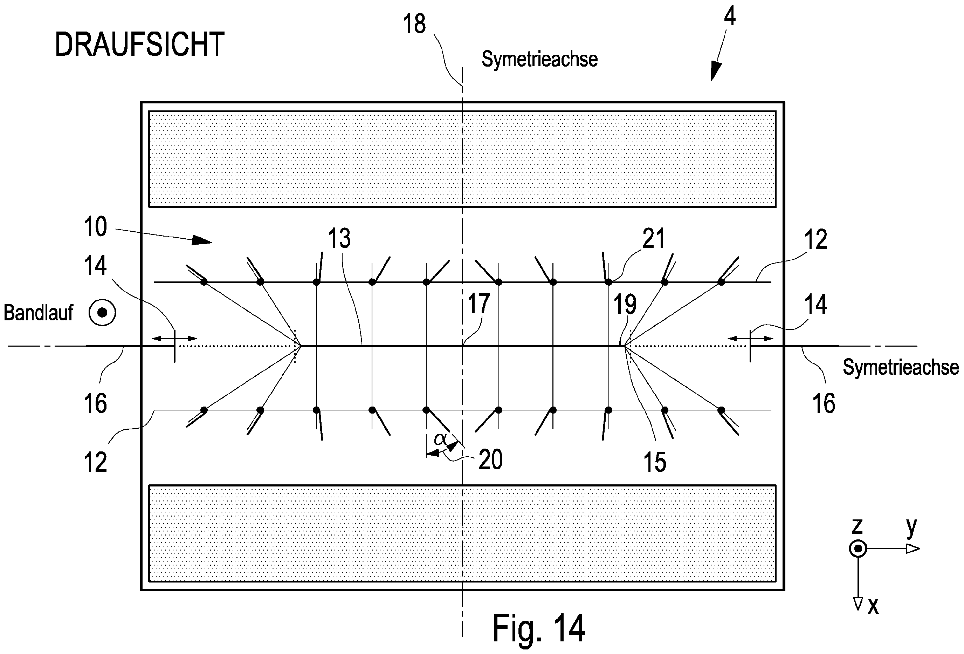

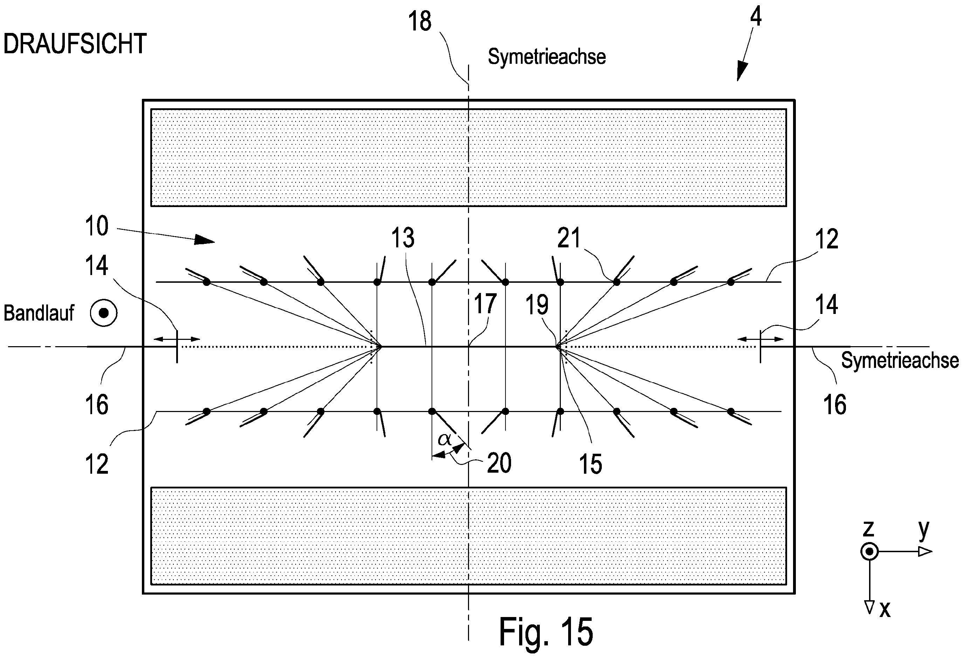

In einer weiteren Ausführungsform mir einer vertikalen Substratführung sind zwei Klappenreihen 12 vorgesehen, die auf einer zum Substrat 13 parallel verlaufenden Ebene angeordnet sind (Figur 14). Jede Klappenreihe 12 umfasst jeweils zehn Monoklappen 8, welche ein Klappensystem bilden. Es sind ebenfalls seitliche Blenden 14 vorgesehen, die der Steuerung der Dampfströmung und des Dampfdruckes dienen. Auch bei einer derartigen Klappenkonfiguration nehmen die Klappenanstellwinkel 20 von der Symmetrieachse 18 weg zum Substratrand 19 hin in geregelten Winkelgrößen ab. Die Abnahme der Klappenanstellwinkel 20 ist bei einem schmalen Substrat 13 schneller als bei einem breiten Substrat 13 (Figur 15).

In einem Monoklappensystem 10 sind die Klappen 7 als sogenannte Monoklappen 8 ausgebildet. Eine Monoklappe 8 weist einen Klappenflügel 22 auf, welcher an einer Welle 21 drehbar angeordnet ist. Die Welle 21 ist als doppelte Welle mit einer Innenwelle und mit einer äußeren Hohlwelle ausgebildet. Die Verstellung des Klappenanstellwinkels 20 erfolgt durch Betätigung der Wellen mittels einer Verstelleinrichtung 23.

In einem Multiklappensystem 11 sind die Klappen 7 als sogenannte Multiklappen 9 ausgebildet. Hierbei sind zwei Klappenflügel 22 an einer Welle 21 angeordnet, welche hierbei vorzugsweise als doppelte Welle mit einer Innenwelle und einer äußeren Hohlwelle ausgebildet ist. Hierdurch kann ein Klappenflügel 22 auf der Innenwelle und ein Klappenflügel 22 an der äußeren Hohlwelle angeordnet werden.

Somit können beide Klappenflügel 22 unabhängig voneinander bewegt und angestellt werden, wobei sowohl der Klappenanstellwinkel 20 zum Substrat 13 als auch der Winkel zueinander einstellbar ist. Hierbei kann ebenfalls vorgesehen sein, dass der Abstand der Wellen 21 zueinander dem doppelten der Breite eines Klappenflügels 22 entspricht oder etwas geringer ist.

Vorzugsweise besitzen die Klappen 7 eine Erstreckung derart, dass sie die Beschichtungseinheit 4 über die gesamte Länge in Transportrichtung des Substrats 13 durchgreifen.

Durch Verwendung der Multiklappen 9 kann die effektive Breite und die Anzahl an Freiheitsgraden einer Klappe 7 erhöht werden. Dies erhöht die Einstellungsvariabilität des Klappensystems und ermöglicht somit eine bessere Anpassung an unterschiedliche Substratbreiten.

Die Klappenflügel 22 können unabhängig voneinander in X/Y- oder Z-Richtung abgewinkelt werden, sodass das Monoklappensystem 10 oder das Multiklappensystem 11 in jeder beliebigen geometrischen Konfiguration und Winkelstellung verändert werden können. Auch einzelne Klappen 7 in einer Klappenreihe 12 können unabhängig voneinander verstellt werden.

Demgemäß können die Klappen 7 in einem Klappensystem beispielsweise eine trichterförmige oder eine pfeilförmige Konfiguration innerhalb einer Klappenreihe 12 besitzen.

In einem Ausführungsbeispiel kann eine Klappenreihe 12 die trichterförmige und die andere Klappenreihe 12 die pfeilförmige Klappenkonfiguration aufweisen.

In einem weiteren Ausführungsbeispiel können alle Klappenreihen 12 die gleiche Klappenkonfiguration aufweisen.

Zudem kann die Erstreckung der Klappenflügel 22 in ihrer Länge variieren.

In einem Ausführungsbeispiel besitzen alle Klappenflügel 22 die gleiche Länge.

In einem weiteren Ausführungsbeispiel können die Klappenflügel 22 unterschiedlich lang ausgebildet sein. So kann ein derartiges Klappensystem lange und kurze Klappenflügel aufweisen. Hierbei ist durch Verwendung unterschiedlich langer Klappenflügel 22 eine alternierende Klappenanordnung innerhalb einer Klappenreihe 12 möglich.

In einem Monoklappensystem 10 können kurze und lange Monoklappen 8 alternierend innerhalb einer Klappenreihe 12 angeordnet sein.

In einem Multiklappensystem 11 kann eine Multiklappe 9 einen kurzen und einen langen Klappenflügel 22 besitzen.

Durch Verwendung unterschiedlich langer Klappenflügel 22 kann die Lenkung des Metalldampfes von der Steuerung der Durchflussrate getrennt werden. Die langen Klappenflügel 22 dienen primär der Lenkung des Gasstromes, während die kurzen Klappenflügel 22 als ein Strömungshindernis zur Einstellung der Durchflussrate fungieren. Die Länge der kurzen Klappenflügel 22 wird so gewählt, dass die Gasströmung auch bei einer senkrechten Ausrichtung der Klappen 7 nicht vollständig unterbunden wird. Sind die Klappen 7 parallel zu einander und parallel zur Strömungsrichtung ausgerichtet, erreicht die Durchflussrate ihren Maximalwert.

Das Klappensystem wirkt in Kombination mit den seitlichen Blenden 14, welche einteilig oder mehrteilig ausgebildet sein können. Hierbei werden konventionelle Seitenwände einer Beschichtungseinheit 4 durch Blenden ersetzt. Dies führt zu höheren Schichtdicken am Substratrand 19. Außerdem wird hierbei eine komplette Abschottung des Substrats 13 durch Seitenwände verhindert.

Die seitlichen Blenden 14 sind beispielsweise mittig und/oder außenmittig drehbar angeordnet. Sie sind in ihrem Winkel verstellbar und können horizontal und/oder lateral verschiebbar ausgeführt werden. Die laterale Verschiebbarkeit der seitlichen Blenden 14 wird dadurch erreicht, dass diese beispielsweise auf Tragarmen gelagert sind, die über einen entsprechenden Verschiebungsfreiheitsgrad zum Substrat 13 verfügen und über einen Antrieb betätigt werden.

In einer vorteilhaften Ausführung beinhaltet jeder Tragarm individuell ansteuerbare Antriebe zur Einstellung der Anstellwinkel der sich darauf befindlichen seitlichen Blenden 14.

Die Verwendung der seitlichen Blenden 14 führt zu einer verbesserten Gleichmäßigkeit der Schicht an den Substraträndern 19. Dies wird durch Aufstau- bzw. Abschirmungswirkungen erreicht. Außerdem kann durch Linearführungen der seitlichen Blenden 14 der Abstand zum Substrat 13 bei variierenden Bandbreiten gezielt verändert werden. Die Verschiebung der seitlichen Blenden 14 mittels Tragarmen hat den Vorteil, im Vergleich zu einer konventionellen Verschiebung, dass keine komplizierte Mechanik mit Linearführungen innerhalb der mit der gasförmigen Beschichtungssubstanz beladenen Beschichtungseinheit 4 notwendig ist.

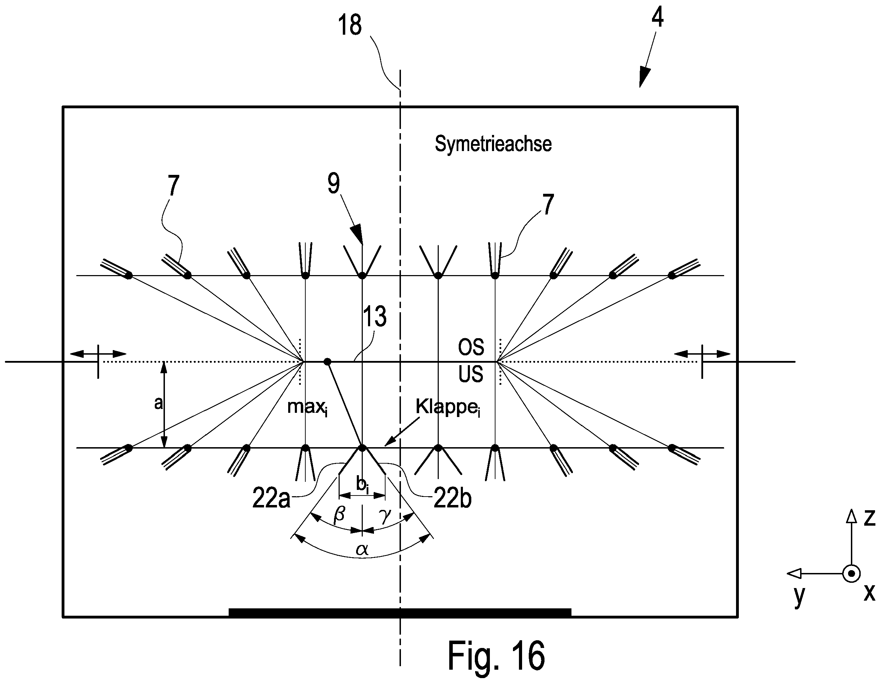

Die Parameter, welche bei der Verstellung der Klappen berücksichtigt werden, sind in Figur 16 dargestellt. Somit wird der maximale Abstand zwischen der Drehachse einer Klappe 7 und dem Substrat 13 mit maxi gekennzeichnet. Der kleinste Abstand zwischen dem Substrat 13 und der substratnächsten Drehachse einer Klappe 7 wird mit a gekennzeichnet. Der Öffnungswinkel $\alpha$ einer Multiklappe 9 besteht aus dem Öffnungswinkel $\beta$ des ersten Klappenflügels 22a und aus dem Öffnungswinkel $\gamma$ des zweiten Klappenflügels 22b und wird als Öffnungsbreite $b_i$ gekennzeichnet.

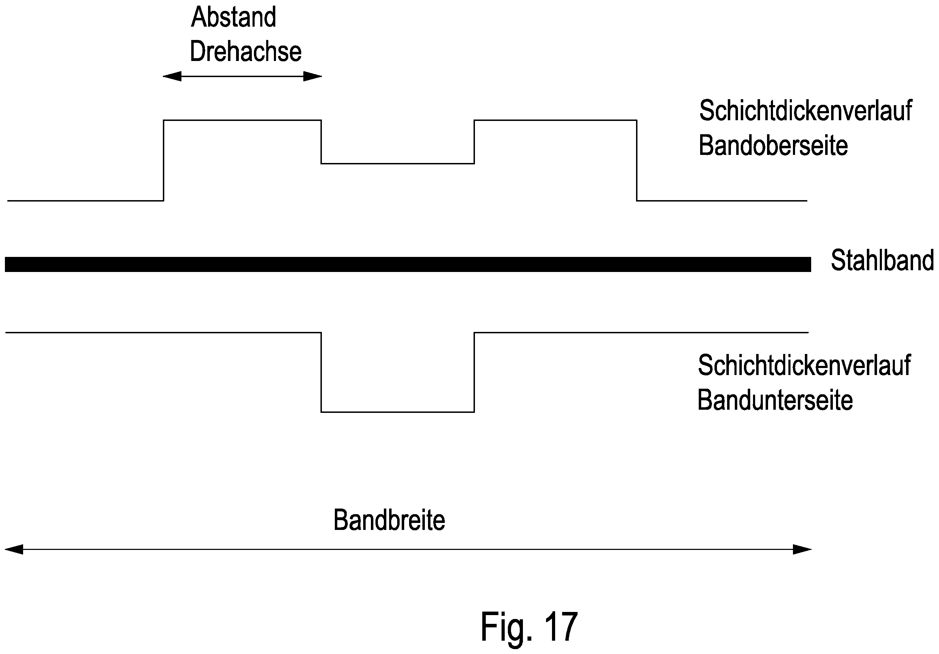

Figur 17 zeigt eine mögliche Schichtdickenverteilung wobei sich diese über die Substratbreite als auch je Substratseite unterschiedlich ausgebildet darstellt.

Die Erfindung wird beispielhaft anhand eines Ausführungsbeispiels erläutert.

**Ausführungsbeispiel**

Es wird ein Substrat 13 beschichtet, das eine Dicke von 1 mm aufweist. Das Substrat 13 wird vertikal in die Z-Richtung befördert. Die Beschichtungseinheit 4 ist mit einem Verdampfer 6, zwei seitlichen Blenden 14 und zwei Klappenreihen 12 ausgestattet, welche jeweils sechs Monoklappen 9 umfassen. Die verdampfernahen Monoklappen 9 weisen eine trichterförmige und die verdampferfernen Monoklappen 9 eine pfeilförmige Konfiguration auf.

Die Partikeldichte direkt am Verdampfer 6 beträgt $6{,}6 \cdot 10^{20}$ Teilchen/m³, während die Partikeldichte an der entgegengesetzten Seite der Beschichtungseinheit 4 $3{,}9 \cdot 10^{20}$ Teilchen/m³ beträgt. Hierbei ist die Partikeldichte an beiden Seiten des Substrats 13 gleichmäßig und beträgt $1{,}42 \cdot 10^{20}$ Teilchen/m³.

Die Verwendung eines derartigen Klappensystems ermöglicht eine gleichmäßige Gasverteilung an der verdampfernahen und verdampferfernen Seite des Substrats 13, sodass eine homogene Schichtdicke über die ganze Breite des Substrats erreicht wird. Außerdem kann durch die sehr niedrige Partikeldichte eine hohe Effizienz der Abscheidung erzielt werden. Darüber hinaus kann hierdurch auch die Gefahr der Tröpfchenbildung am Substrat weiter reduziert werden.

Durch die Verwendung des erfindungsgemäßen Klappensystems in Verbindung mit den seitlichen Blenden 14 wird eine gleichmäßige Gasverteilung im Bereich des Substrats 13 erreicht und zwar unabhängig von der Position oder Anzahl der Verdampfer. Dies führt zu einer homogenen Schichtdicke über die ganze Breite des Substrats 13. Zudem wird die Abnahme der Schichtdicke am Rand gering gehalten.

Ferner werden im Bereich des Substrats 13 sehr niedrige Partikeldichten erreicht. Dies erhöht die Prozesseffizienz und verringert die Gefahr der Tröpfchenbildung.

Die flexible Einstellung der Klappenanstellwinkel 20 sowie der seitlichen Blenden 14 ermöglicht eine flexible und schnelle Anpassung an unterschiedlichen Substratbreiten.

Mit der Erfindung gelingt es somit, ein effizientes und flexibles Klappensystem für die Dampfphasenabscheidung von Schichten auf unterschiedlich breite Substrate 13 zu schaffen. Erfindungsgemäß lassen sich mit dem Klappensystem gleichmäßige Schichten bei geringem Strömungswiderstand abscheiden. Außerdem wird mit der Erfindung ein Ansteuerungssystem geschaffen, das seitliche Blenden 14 für den Randbereich des Substrats 13 umfasst und Einstellungsmöglichkeiten für die Beschichtung unterschiedlich breiter Substrate 13 bietet. Dies ermöglicht eine effiziente Anlagenauslastung.

**Patentansprüche**

1. PVD-Verfahren zum Abscheiden von metallischen Schichten aus einer Dampfphase auf metallischen Substraten, insbesondere auf Substraten mit unterschiedlicher Bandbreite, wobei

in einer Beschichtungseinheit mindestens ein Verdampfer und ein Substrat vorhanden sind und zwischen dem Verdampfer und dem Substrat ein Strömungsweg für die Beschichtungspartikel besteht,

**dadurch gekennzeichnet, dass**
im Strömungsweg mindestens eine Klappe (7) pro Substratseite vorhanden ist, welche zur Beeinflussung des Strömungswiderstands um eine Drehachse drehbar angeordnet ist, wobei die Drehachse in einer Ebene parallel zur Substratebene (13) und vorzugsweise längs zur Transportrichtung des Substrats (13) verläuft, wobei die Klappen (7) von einer Symmetrieachse (18) weg zum Substratrand (19) hin symmetrisch angeordnet sind, sodass der Klappenanstellwinkel (20) zum Substratrand (19) hin stetig abnimmt.

2. PVD-Verfahren nach Anspruch 1, wobei die Klappen (7) einen Klappenanstellwinkel (20) besitzen, welcher mittels einer Verstelleinrichtung (23) verstellbar ist, sodass die Klappen (7) unabhängig voneinander verstellbar sind.

3. PVD-Verfahren nach Anspruch 1 oder 2, wobei die Klappen (7) in Verbindung mit beidseitig angeordneten, seitlichen Blenden (14) wirken.

4. PVD-Verfahren nach Anspruch 3, wobei die seitlichen Blenden (14) einteilig oder mehrteilig ausgebildet sind und mittels einer Verschiebeinrichtung (16) zur Adaptierung an die jeweilige Substratbreite verschiebbar sind.

5. PVD-Verfahren nach einem der vorhergehenden Ansprüche, wobei der Klappenanstellwinkel (20) an der korrespondierenden Klappe der verdampfernahen Seite des Substrats (13) größer eingestellt wird als an der zugehörigen, über das Substrat gespiegelten Klappe an der verdampferfernen Seite des Substrats (13).

6. PVD-Verfahren nach einem der vorhergehenden Ansprüche, wobei bei jenen Klappen deren Drehachse weiter von der Symmetrieebene entfernt sind als die halbe Bandbreite, der Klappenanstellwinkel (20) derart eingestellt ist, sodass die Klappenflügel (22) direkt auf die nächstliegende Substratkante (15) zeigen.

7. PVD-Verfahren nach einem der vorhergehenden Ansprüche, wobei nach einem Beschichtungsvorgang die abgeschiedene Schichtdicke in einer Messeinheit (5) gemessen wird, wobei die Verstelleinrichtung (23) in Verbindung mit der Messeinheit (5) wirkt und
die Einstellung des Klappenanstellwinkels (20) in Abhängigkeit der Messergebnisse erfolgt.

8. PVD Verfahren nach einem der vorhergehenden Ansprüche, **dadurch gekennzeichnet, dass** bei einer vertikalen Bandführung die gegenüberliegenden Klappen beidseitig des Substrates spiegelsymetrisch angestellt werden.

9. PVD Verfahren nach einem der Ansprüche 1 bis 8, **dadurch gekennzeichnet, dass** bei horizontaler Bandführung die gegenüberliegenden Klappen beidseitig des Substrates unterschiedlich angestellt vorzugsweise der Klappenanstellwinkel der verdampfernahen Klappen größer als jener der verdampferfernen Klappen bevorzugt um mindestens 10° größer werden.

10. Vorrichtung zum PVD-Beschichten von metallischen Substraten, insbesondere von Substraten mit unterschiedlicher Substratbreite, insbesondere nach einem Verfahren nach einem der vorhergehenden Ansprüchen,
**dadurch gekennzeichnet, dass**
in einer Beschichtungseinheit (4), die insbesondere als Beschichtungskammer ausgebildet ist, mindestens ein Verdampfer (6) vorhanden ist und zwischen dem Verdampfer (6) und einem durch die Beschichtungseinrichtung führbaren Substrat (13) ein Strömungsweg für die Beschichtungspartikel besteht, wobei im Strömungsweg mindestens eine Klappe (7) pro Substratseite vorhanden ist, welche zur Beeinflussung des Strömungswiderstands um eine Drehachse drehbar angeordnet ist, wobei die Drehachse in einer Ebene parallel zur Substratebene (13) und vorzugsweise längs zur Transportrichtung des Substrats (13) verläuft, wobei die Klappen (7) von einer Symmetrieachse (18) weg zum Substratrand (19) hin symmetrisch angeordnet sind und einen Klappenanstellwinkel (20) aufweisen, der zum Substratrand (19) hin stetig abnimmt.

11. Vorrichtung nach Anspruch 10, wobei die Klappen (7) einen Klappenanstellwinkel (20) besitzen, welcher mittels einer Verstelleinrichtung (23) verstellbar ist, sodass die Klappen (7) unabhängig voneinander verstellbar sind.

12. Vorrichtung nach Anspruch 10 oder 11, wobei zusätzlich zu den Klappen (7) zwei seitliche Blenden (14) jeweils eine auf beiden Seiten des Substrats angeordnet sind.

13. Vorrichtung nach Anspruch 12, wobei die seitlichen Blenden (14) einteilig oder mehrteilig ausgebildet sind und mittels einer Verschiebeeinrichtung (16) zur Adaptierung an die jeweilige Substratbreite verschiebbar sind.

**14.** Vorrichtung nach einem der Ansprüche 10 bis 13, wobei nach der Beschichtungseinheit (4) eine Messeinheit (5) angeordnet ist, welche mit der Verstelleinrichtung (23) der Klappen (7) gekoppelt ist.

**15.** Vorrichtung nach einem Ansprüche 10 bis 14, **dadurch gekennzeichnet, dass** bei einer vertikalen Bandführung die gegenüberliegenden Klappen beidseitig des Substrates spiegelsymetrisch angestellt sind.

**Claims**

**1.** PVD process for depositing metallic layers from a vapour phase onto metallic substrates, in particular onto substrates with different bandwidths, wherein

in a coating unit at least one evaporator and one substrate are present and there is a flow path for the coating particles between the evaporator and the substrate,
**characterized in that**
at least one flap (7) per substrate side is present in the flow path, which is rotatably arranged about an axis of rotation to influence the flow resistance, wherein the axis of rotation runs in a plane parallel to the substrate plane (13) and preferably longitudinally to the transport direction of the substrate (13), wherein the flaps (7) are arranged symmetrically away from a symmetry axis (18) towards the substrate edge (19), so that the flap angle of attack (20) decreases continuously towards the substrate edge (19).

**2.** PVD process according to Claim 1, wherein the flaps (7) have a flap angle of attack (20) that can be adjusted by means of an adjustment apparatus (23), so that the flaps (7) are adjustable independently of one another.

**3.** PVD process according to Claim 1 or 2, wherein the flaps (7) act in conjunction with lateral blinds (14) arranged on both sides.

**4.** PVD process according to Claim 3, wherein the lateral blinds (14) are formed in one piece or in multiple pieces and are displaceable by means of a displacement apparatus (16) for adaptation to the respective substrate width.

**5.** PVD process according to any one of the preceding claims, wherein the flap angle of attack (20) is set to be greater at the corresponding flap of the side of the substrate (13) close to the evaporator than at the associated flap mirrored over the substrate on the side of the substrate (13) distal from the evaporator.

**6.** PVD process according to any one of the preceding claims, wherein for those flaps whose axis of rotation is further away from the symmetry plane than half the bandwidth, the flap angle of attack (20) is set in such a manner that the flap wings (22) point directly to the nearest substrate edge (15).

**7.** PVD process according to any one of the preceding claims, wherein after a coating process, the deposited layer thickness is measured in a measuring unit (5), wherein the adjustment apparatus (23) acts in conjunction with the measuring unit (5) and the flap angle of attack (20) is set depending on the measurement results.

**8.** PVD process according to any one of the preceding claims, **characterized in that** in a vertical band guide, the opposing flaps are set mirror-symmetrically on both sides of the substrate.

**9.** PVD process according to any one of Claims 1 to 8, **characterized in that** in a horizontal band guide, the opposing flaps are set differently on both sides of the substrate, the flap angle of attack of the flaps near the evaporator is preferably greater than that of the flaps distal from the evaporator, preferably at least 10° greater.

**10.** Device for PVD coating of metallic substrates, in particular of substrates with different substrate widths, in particular according to a process according to any one of the preceding claims,
**characterized in that**
in a coating unit (4) that is designed in particular as a coating chamber, at least one evaporator (6) is present, and between the evaporator (6) and a substrate (13) that can be guided through the coating apparatus, there is a flow path for the coating particles, wherein at least one flap (7) per substrate side is present in the flow path, which is rotatably arranged about an axis of rotation to influence the flow resistance, wherein the axis of rotation lies in a plane parallel to the substrate plane (13) and preferably longitudinally to the transport direction of the substrate (13), wherein the flaps (7) are arranged symmetrically away from a symmetry axis (18) towards the substrate edge (19) and have a flap angle of attack (20) that decreases continuously towards the substrate edge (19).

11. Device according to Claim 10, wherein the flaps (7) have a flap angle of attack (20) that can be adjusted by means of an adjustment apparatus (23), so that the flaps (7) are adjustable independently of one another.

12. Device according to Claim 10 or 11, wherein two lateral blinds (14) are arranged one on either side of the substrate in addition to the flaps (7).

13. Device according to Claim 12, wherein the lateral blinds (14) are formed in one piece or in multiple pieces and are displaceable by means of a displacement apparatus (16) for adaptation to the respective substrate width.

14. Device according to any one of Claims 10 to 13, wherein a measuring unit (5) that is coupled to the adjustment apparatus (23) of the flaps (7) is arranged after the coating unit (4).

15. Device according to any one of Claims 10 to 14, **characterized in that** in a vertical band guide, the opposing flaps are set mirror-symmetrically on both sides of the substrate.


**Revendications**

1. Procédé de dépôt physique en phase vapeur destiné au dépôt de couches métalliques à partir d'une phase vapeur sur des substrats métalliques, notamment sur des substrats ayant une largeur de bande différente,

   au moins un évaporateur et un substrat étant présents dans une unité de revêtement, et une voie d'écoulement destinée aux particules de revêtement étant aménagée entre l'évaporateur et le substrat,
   **caractérisé en ce que**
   au moins une trappe (7) par côté du substrat étant présente dans la voie d'écoulement, ladite trappe étant disposée de manière à pouvoir tourner autour d'un axe de rotation pour agir sur la résistance à l'écoulement, l'axe de rotation s'étendant dans un plan parallèle au plan de substrat (13) et, de préférence, dans la direction de transport du substrat (13), les trappes (7) étant disposées de manière symétrique en s'éloignant d'un axe de symétrie (18) vers le bord (19) du substrat, de sorte que l'angle d'attaque (20) des trappes diminue constamment en direction du bord (19) du substrat.

2. Procédé de dépôt physique en phase vapeur selon la revendication 1, dans lequel les trappes (7) possèdent un angle d'attaque de trappe (20) qui est réglable au moyen d'un dispositif de réglage (23), de sorte que les trappes (7) peuvent être réglées indépendamment les unes des autres.

3. Procédé de dépôt physique en phase vapeur selon la revendication 1 ou 2, dans lequel les trappes (7) agissent en liaison avec des écrans latéraux (14) disposés des deux côtés.

4. Procédé de dépôt physique en phase vapeur selon la revendication 3, dans lequel les écrans latéraux (14) sont réalisés en une ou plusieurs parties et peuvent être déplacés au moyen d'un dispositif de déplacement (16) pour les adapter à la largeur respective du substrat.

5. Procédé de dépôt physique en phase vapeur selon l'une des revendications précédentes, dans lequel l'angle d'attaque de la trappe (20) est réglé plus grand sur la trappe correspondant du côté du substrat (13) proche de l'évaporateur que sur la trappe correspondant du côté du substrat (13) éloigné de l'évaporateur, qui est réfléchi sur le substrat.

6. Procédé de dépôt physique en phase vapeur selon l'une des revendications précédentes, dans lequel, pour les trappes dont l'axe de rotation est plus éloigné du plan de symétrie que la moitié de la largeur de la bande, l'angle d'attaque (20) de la trappe est réglé de telle sorte que les ailes (22) de trappe pointent directement vers le bord (15) du substrat le plus proche.

7. Procédé de dépôt physique en phase vapeur selon l'une des revendications précédentes, dans lequel, après une opération de revêtement, l'épaisseur de couche déposée est mesurée dans une unité de mesure (5), le dispositif de réglage (23) agissant en liaison avec l'unité de mesure (5) et le réglage de l'angle d'attaque de la trappe (20) étant effectué en fonction des résultats de mesure.

**8.** Procédé de dépôt physique en phase vapeur selon l'une des revendications précédentes, **caractérisé en ce que**, dans le cas d'un guidage vertical de la bande, les trappes opposées sont placées de manière symétrique de part et d'autre du substrat.

**9.** Procédé de dépôt physique en phase vapeur selon l'une des revendications 1 à 8, **caractérisé en ce que**, lors d'un guidage horizontal de la bande, les trappes opposées des deux côtés du substrat sont réglées différemment, de préférence l'angle d'attaque des trappes proches de l'évaporateur est supérieur à celui des trappes éloignées de l'évaporateur, de préférence d'au moins 10°.

**10.** Dispositif destiné au revêtement de dépôt physique en phase vapeur de substrats métalliques, en particulier de substrats ayant des largeurs de substrat différentes, en particulier selon un procédé selon l'une des revendications précédentes, **caractérisé en ce que**
dans une unité de revêtement (4), qui est conçue notamment comme une chambre de revêtement, se trouve au moins un évaporateur (6) et entre l'évaporateur (6) et un substrat (13) pouvant être guidé à travers le dispositif de revêtement, il existe une voie d'écoulement pour les particules de revêtement, au moins une trappe (7) par côté du substrat étant présente dans la voie d'écoulement, qui est disposée de manière à pouvoir tourner autour d'un axe de rotation pour influencer la résistance à l'écoulement, l'axe de rotation s'étendant dans un plan parallèle au plan du substrat (13) et de préférence le long de la direction de transport du substrat (13), les trappes (7) étant disposées de manière symétrique en s'éloignant d'un axe de symétrie (18) vers le bord du substrat (19) et présentant un angle d'attaque de la trappe (20) qui diminue constamment vers le bord du substrat (19).

**11.** Dispositif selon la revendication 10, dans lequel les trappes (7) possèdent un angle d'attaque de trappe (20) qui est réglable au moyen d'un dispositif de réglage (23), de sorte que les trappes (7) peuvent être réglées indépendamment les unes des autres.

**12.** Dispositif selon la revendication 10 ou 11, dans lequel, en plus des trappes (7), deux écrans latéraux (14) sont disposés un de chaque côté du substrat.

**13.** Dispositif selon la revendication 12, dans lequel les écrans latéraux (14) sont réalisés en une ou plusieurs parties et peuvent être déplacés au moyen d'un dispositif de déplacement (16) pour les adapter à la largeur respective du substrat.

**14.** Dispositif selon l'une des revendications 10 à 13, dans lequel une unité de mesure (5) est disposée en aval de l'unité de revêtement (4) et couplée au dispositif de réglage (23) des trappes (7).

**15.** Dispositif selon l'une des revendications 10 à 14, **caractérisé en ce que**, dans le cas d'un guidage vertical de la bande, les trappes opposées sont placées de manière symétrique de part et d'autre du substrat.

Fig. 1

EP 4 200 459 B1

Fig. 2

EP 4 200 459 B1

Fig. 3

Fig. 4

Fig. 5

Fig. 6

EP 4 200 459 B1

Fig. 7

EP 4 200 459 B1

Fig. 8

EP 4 200 459 B1

# Anlagenschema Vertikal

Fig. 9

EP 4 200 459 B1

DRAUFSICHT

Fig. 10

EP 4 200 459 B1

Fig. 11

DRAUFSICHT

Fig. 12

EP 4 200 459 B1

DRAUFSICHT

Fig. 13

DRAUFSICHT

Fig. 14

EP 4 200 459 B1

DRAUFSICHT

Fig. 15

EP 4 200 459 B1

Fig. 16

Fig. 17

EP 4 200 459 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 8436318 B2
- EP 2231895 A1

### In der Beschreibung aufgeführte Nicht-Patentliteratur

- **B. SCHUHMACHER.** Innovative steel strip coatings by means of PVD in a continuous pilot line: process technology and coating development. *Surface and Coatings Technology,* 2003, vol. 163-164, 703-709